(19) Europäisches Patentamt
European Patent Office
Office européen des brevets

(11) **EP 4 137 999 B1**

(12) **FASCICULE DE BREVET EUROPEEN**

(45) Date de publication et mention de la délivrance du brevet:
**11.03.2026 Bulletin 2026/11**

(21) Numéro de dépôt: **22191274.4**

(22) Date de dépôt: **19.08.2022**

(51) Classification Internationale des Brevets (IPC):
**G06N 3/063** (2023.01)    **G06N 3/0495** (2023.01)

(52) Classification Coopérative des Brevets (CPC):
**G06N 3/063; G06N 3/0495**

(54) **CIRCUIT NEUROMORPHIQUE À BASE DE CELLULES RRAM 2T2R**

NEUROMORPHER SCHALTKREIS AUF DER BASIS VON 2T2R-RRAM-ZELLEN

NEUROMORPHIC CIRCUIT MADE OF 2T2R RRAM CELLS

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **20.08.2021 FR 2108809**

(43) Date de publication de la demande:
**22.02.2023 Bulletin 2023/08**

(73) Titulaires:
• **Commissariat à l'Energie Atomique et aux Energies Alternatives**
**75015 Paris (FR)**
• **Centre national de la recherche scientifique**
**75016 Paris (FR)**
• **Université d'Aix-Marseille**
**13007 Marseille (FR)**

(72) Inventeurs:
• **EZZADEEN, Mona**
**38054 GRENOBLE CEDEX 9 (FR)**
• **NOEL, Jean-Philippe**
**38054 GRENOBLE CEDEX 9 (FR)**
• **GIRAUD, Bastien**
**38054 GRENOBLE CEDEX 9 (FR)**
• **PORTAL, Jean-Michel**
**13119 SAINT SAVOURNIN (FR)**
• **ANDRIEU, François**
**38054 GRENOBLE CEDEX 9 (FR)**

(74) Mandataire: **Lavoix**
**2, place d'Estienne d'Orves**
**75441 Paris Cedex 09 (FR)**

(56) Documents cités:
**US-A1- 2020 311 533     US-A1- 2021 166 108**

• **TIFENN HIRTZLIN ET AL: "Digital Biologically Plausible Implementation of Binarized Neural Networks with Differential Hafnium Oxide Resistive Memory Arrays", ARXIV.ORG, CORNELL UNIVERSITY LIBRARY, 201 OLIN LIBRARY CORNELL UNIVERSITY ITHACA, NY 14853, 12 August 2019 (2019-08-12), XP081547017**
• **WANG LINFANG ET AL: "Efficient and Robust Nonvolatile Computing-In-Memory Based on Voltage Division in 2T2R RRAM With Input-Dependent Sensing Control", IEEE TRANSACTIONS ON CIRCUITS AND SYSTEMS II: EXPRESS BRIEFS, IEEE, USA, vol. 68, no. 5, 19 March 2021 (2021-03-19), pages 1640 - 1644, XP011851879, ISSN: 1549-7747, [retrieved on 20210429], DOI: 10.1109/TCSII.2021.3067385**
• **VALAVI HOSSEIN ET AL: "A Mixed-Signal Binarized Convolutional-Neural-Network Accelerator Integrating Dense Weight Storage and Multiplication for Reduced Data Movement", 2018 IEEE SYMPOSIUM ON VLSI CIRCUITS, IEEE, 18 June 2018 (2018-06-18), pages 141 - 142, XP033427817, DOI: 10.1109/VLSIC.2018.8502421**
• **BANKMAN DANIEL ET AL: "An always-on 3.8 [mu]J/86% CIFAR-10 mixed-signal binary CNN processor with all memory on chip in 28nm CMOS", 2018 IEEE INTERNATIONAL SOLID - STATE CIRCUITS CONFERENCE - (ISSCC), IEEE, 11 February 2018 (2018-02-11), pages 222 - 224, XP033328409, DOI: 10.1109/ISSCC.2018.8310264**

EP 4 137 999 B1

**EP 4 137 999 B1**

**Description**

La présente invention concerne un circuit neuromorphique propre à mettre en oeuvre un réseau de neurones.

Pour de multiples applications, parmi lesquelles le traitement automatique de données, l'aide au diagnostic, l'analyse prédictive, les véhicules autonomes, la bioinformatique ou la surveillance, il est connu d'utiliser des algorithmes d'apprentissage automatique faisant partie de programmes pouvant être exécutés sur des processeurs tels que les CPU ou les GPU. Un CPU est un processeur, le sigle CPU provenant du terme anglais « *Central Processing Unit* » signifiant littéralement unité centrale de traitement tandis qu'un GPU est un processeur graphique, le sigle GPU provenant du terme anglais « *Graphics Processing Unit* » signifiant littéralement unité graphique de traitement.

Parmi les techniques de mise en oeuvre d'apprentissage, l'emploi de réseaux de neurones est de plus en plus répandu, ces structures étant considérées comme très prometteuses du fait de leurs performances pour de nombreuses tâches telles que la classification automatique de données, la reconnaissance de motifs, la traduction et la compréhension automatique de langues, le contrôle robotique, la navigation automatique, les systèmes de recommandations, la détection d'anomalies, la détection de fraudes, l'étude de l'ADN ou encore la découverte de nouvelles molécules.

Un réseau de neurones est en général composé d'une succession de couches de neurones dont chacune prend ses entrées sur les sorties de la couche précédente. Plus précisément, chaque couche comprend des neurones prenant leurs entrées sur les sorties des neurones de la couche précédente. Chaque couche est reliée par une pluralité de synapses. Un poids synaptique est associé à chaque synapse. C'est un nombre réel, qui prend des valeurs positives comme négatives. Pour chaque couche, l'entrée d'un neurone est la somme pondérée des sorties des neurones de la couche précédente, la pondération étant faite par les poids synaptiques.

Pour une implémentation dans un CPU ou un GPU, une problématique de goulot d'étranglement de Von Neumann (également appelée « *Von Neumann bottleneck* » selon sa dénomination anglaise) apparaît du fait que l'implémentation d'un réseau de neurones profond (à plus de trois couches et allant jusqu'à plusieurs dizaines) implique d'utiliser à la fois la ou les mémoires et le processeur alors que ces derniers éléments sont séparés spatialement. Il en résulte un engorgement du bus de communication entre la ou les mémoires et le processeur à la fois pendant que le réseau de neurones une fois entraîné est utilisé pour réaliser une tâche, et, à plus forte raison, pendant que le réseau de neurones est entraîné, c'est-à-dire pendant que ses poids synaptiques sont réglés pour résoudre la tâche en question avec un maximum de performance.

Il est donc souhaitable de développer des architectures matérielles dédiées, entremêlant mémoire et calcul, pour réaliser des réseaux de neurones rapides, à faible consommation et capables d'apprendre en temps réel.

Il est connu un réseau de neurones reposant sur des technologies de type optique.

Un autre champ de recherche porte sur la réalisation de neurones et de synaspes de réseaux de neurones sur la base d'une technologie de type CMOS. Il est entendu par le sigle « CMOS », oxyde métallique semi-conducteur complémentaire (acronyme provenant de l'expression anglaise « *Complementary Metal-Oxide-Semiconductor* »). Le sigle CMOS désigne aussi bien un procédé de fabrication qu'un composant obtenu par un tel procédé de fabrication.

Toutefois, selon chacune de ces technologies, chaque neurone occupe plusieurs dizaines de micromètres de côté. En outre, chaque synapse occupe également plusieurs dizaines de micromètres de côté. Il en résulte que, sur une surface limitée correspondant par exemple à une puce électronique, le nombre de neurones et de synapses qui peuvent être intégrés est limité, ce qui résulte en une diminution des performances du réseau de neurones.

De ce fait, pour diminuer l'encombrement, il est spécifiquement étudié des architectures dans lesquelles les synapses sont memristives.

Des synapses memristives sont des synapses utilisant des memristors. En électronique, le memristor (ou memristance) est un composant électronique passif. Le nom est un mot-valise formé à partir des deux mots anglais memory et resistor. Un memristor est un composant de mémoire non-volatile, la valeur de sa résistance électrique changeant avec l'application d'une tension pendant une certaine durée et restant à cette valeur en l'absence de tension.

Un exemple d'une telle implémentation est proposé dans un article de L. Wang et al. intitulé « Efficient and Robust Nonvolatile Computing-In-Memory based on Voltage Division 2T2R RRAM with Input-Dependent Sensing Control » publié le 19 mars 2021 dans la revue Transactions on Circuits and Systems II: Express Briefs. Le réseau de neurones est réalisé par un ensemble de cellules mémoires reliées à un circuit de lecture spécifique.

Il est à noter que cette implémentation porte sur un réseau de neurones particulier qui est un réseau de neurones binaire, c'est-à-dire un réseau dans lequel les neurones et les synapses ne peuvent prendre que des valeurs binaires. Ces réseaux de neurones ont l'avantage de permettre des calculs plus simples mais présentent encore de bonnes performances durant l'inférence, notamment pour des applications liées à la surveillance.

Toutefois, l'implémentation proposée par l'article de L. Wang et al. est relativement encombrante et difficilement intégrable dans une structure de cellules mémoires. L'article de T. Hirtzil et al. intitulé "Digital Biologically Plausible Implementation of Binarized Neural Networks with Differential Hafnium Oxide Resistive Memory Arrays" publié le 12 août 2019 fournit une autre implémentation de circuit neuromorphique à base de cellules RRAM 2T2R.

Il existe donc un besoin pour un circuit neuromorphique permettant de réaliser un réseau de neurones binaire qui soit moins encombrant et présente une meilleure intégrabilité dans un ensemble de cellules mémoires.

A cet effet, la description décrit un circuit neuromorphique propre à mettre en oeuvre un réseau de neurones, le circuit neuromorphique comprenant :

- des lignes de mot,
- des paires de lignes de bits complémentaires,
- des lignes de source,
- un ensemble de cellules élémentaires organisées selon une matrice bidimensionnelle comportant des lignes et des colonnes,

   l'ensemble de cellules élémentaires comportant un ensemble de mémorisation regroupant un ensemble de lignes de cellules élémentaires, les cellules élémentaires de l'ensemble de mémorisation étant des cellules mémoires, les cellules mémoires d'une même ligne étant sélectionnables par une ligne de mot, les cellules mémoires d'une même colonne étant reliées à une paire de lignes de bits complémentaires et une ligne de source,
   chaque cellule mémoire comprenant deux memristors et deux commutateurs, chaque memristor étant relié à la même ligne de source et à un commutateur respectif, chaque memristor mémorisant respectivement un poids ou l'inverse du même poids en présentant respectivement des première et deuxième valeurs de résistances différentes, les commutateurs étant reliés, pour leur activation, à une ligne de mot et reliés respectivement à une paire de lignes de bits complémentaires,

- un circuit électronique implémentant un neurone présentant une sortie et comportant :

   - un ensemble de composants logiques, chaque composant logique présentant une unité logique comprenant une entrée connectée à une ligne de source respective, l'unité logique étant propre à effectuer une opération logique présentant un basculement entre une valeur basse et une valeur haute en fonction de la valeur de la ou des entrées de l'unité logique, chaque unité logique réalisant une fonction logique de type inverseur ou double inverseur,
   - une unité de comptage, l'unité de comptage étant propre à compter le nombre de valeurs hautes ou basses en sortie des composants logiques, l'unité de comptage étant un pont, un pont étant un ensemble de mêmes éléments en parallèle et reliés entre eux sur une de leurs bornes à une sortie de l'unité de comptage, chaque élément étant relié à un composant logique respectif et étant une résistance ou un condensateur,
   - une unité de comparaison comportant un comparateur et un générateur de tension de comparaison, le comparateur étant propre à comparer la sortie de l'unité de comptage à la tension de comparaison générée par le générateur de tension de comparaison pour émettre en sortie un signal dépendant de la comparaison et correspondant à la sortie du circuit électronique implémentant un neurone.

Selon des modes de réalisation particuliers, le circuit neuromorphique présente une ou plusieurs des caractéristiques suivantes, prise(s) isolément ou selon toutes les combinaisons techniquement possibles :

- chaque memristor comporte un état vierge, l'unité de comptage étant une ligne de cellules élémentaires, chaque cellule élémentaire de l'unité de comptage étant une cellule comprenant deux memristors dans l'état vierge et deux commutateurs, chaque memristor dans l'état vierge étant connecté à l'autre memristor dans l'état vierge et à un commutateur respectif, les commutateurs étant reliés entre eux ;
- chaque unité logique comprend un inverseur formé à partir d'une cellule élémentaire comprenant deux memristors et deux commutateurs, chaque memristor étant connecté à l'autre memristor et à un commutateur respectif, une piste de court-circuit étant agencée pour court-circuiter les deux memristors, un des commutateurs étant relié à la masse et à l'entrée de l'unité logique pour sa commande et l'autre commutateur étant relié à un potentiel d'alimentation et monté en diode ;
- chaque unité logique comprend un inverseur formé à partir d'une cellule élémentaire comprenant deux memristors et deux commutateurs, chaque memristor étant connecté à l'autre memristor et à un commutateur respectif, un premier commutateur étant relié à la masse et à l'entrée de l'unité logique pour sa commande et le deuxième commutateur étant relié à un potentiel d'alimentation et monté en diode, une piste de court-circuit étant agencée pour court-circuiter le memristor relié au premier commutateur ;
- un premier contrôleur permettant de sélectionner les cellules élémentaires d'une ligne qui sont reliées à une même ligne de mots, et comprenant un deuxième contrôleur reliés aux paires de lignes de bit et permettant d'appliquer sur chaque paire de ligne de bits des tensions différentes et symétriques par rapport à une tension milieu, la tension appliquée sur une ligne de bit étant supérieure ou inférieur à celle appliquée sur la ligne de bit complémentaire associée selon la valeur d'un signal d'entrée, chaque signal d'entrée correspondant à une entrée d'une synapse reliée audit neurone ;

- l'ensemble formé par chaque unité logique est réalisé à partir d'au moins une ligne de cellules élémentaires n'appartenant pas à l'ensemble de mémorisation ;

- chaque unité logique correspond à un inverseur formé desdits commutateurs de chaque cellule élémentaire de l'unité de comptage et d'un transistor PMOS dont le drain est relié à une tension d'alimentation, la grille est reliée à une ligne de source SL et la source est reliée aux drains desdits commutateurs ;

- le générateur de tension de comparaison est un générateur de tension fixe ;

- le générateur de tension de comparaison est un deuxième pont présentant les mêmes éléments que l'unité de comptage, chaque élément du deuxième pont étant relié à un inverseur connecté à une unité logique respective ;

- les éléments des deux ponts sont des condensateurs présentant la même capacité, le générateur de tension de comparaison et l'unité de comptage comportant un condensateur de décalage, le condensateur de décalage présentant une capacité égale à la moitié de la capacité d'un condensateur d'un des deux ponts ;

- l'opération logique effectuée par chaque unité logique est choisie parmi : un ou-exclusif avec une entrée fixée à 0, une inversion, un non-et avec une des deux entrées fixées à 1, un non-ou avec une des deux entrées fixées à 0 ;

- le circuit neuromorphique comporte des transistors de rappel, un des transistors de rappel étant relié à l'ensemble des éléments de l'unité de comptage et les autres transistors de rappel étant reliés à une ligne de source respective, les transistors de rappel étant propres à effacer les éléments ;

- le circuit neuromorphique comporte plusieurs ensembles distincts de cellules élémentaires propres à fonctionner en parallèle ;

- les lignes de sources présentent plusieurs portions, des portions de ces lignes étant spécifiques à un ensemble de cellules élémentaires ;

- le circuit neuromorphique est un circuit intégré tridimensionnel ;

- le circuit neuromorphique comporte des unités de biais modifiant la tension de comparaison ;

- le circuit neuromorphique prend en entrée des valeurs codées sur plusieurs bits, chaque bit prenant 2 valeurs possibles, le circuit neuromorphique comprenant une unité de transfert suivie d'une unité d'accumulation ;

- l'unité de transfert et l'unité d'accumulation comportent un interrupteur et un condensateur ;

- le circuit neuromorphique comporte un comparateur en amont des deux unités, et

- l'unité de transfert et l'unité d'accumulation sont réalisées selon un montage différentiel.

Des caractéristiques et avantages de l'invention apparaîtront à la lecture de la description qui va suivre, donnée uniquement à titre d'exemple non limitatif, et faite en référence aux dessins annexés, sur lesquels :

- la figure 1 est une représentation schématique d'un exemple de circuit neuromorphique réalisant physiquement un réseau de neurones,

- la figure 2 est une représentation schématique d'un exemple de cellule mémoire faisant partie du circuit neuromorphique,

- la figure 3 est un graphe montrant l'effet de la variabilité des valeurs des résistances des états d'un memristor,

- la figure 4 est une représentation schématique d'un exemple de circuit électronique implémentant un neurone,

- la figure 5 est une représentation schématique d'un autre exemple de circuit électronique implémentant un neurone,

- la figure 6 est une représentation schématique d'un exemple de réalisation d'un composant réalisant une opération XNOR et faisant partie du neurone de la figure 4,

- la figure 7 illustre les quatre cas possibles de fonctionnement du composant XNOR de la figure 6,

- la figure 8 est une représentation schématique de la tension en sortie du composant XNOR de la figure 6 dans certains cas de la figure 7,

- la figure 9 est une représentation schématique d'un circuit implémentant les neurones du circuit neuromorphique à base de mémoires vives statiques selon un premier document de l'état de la technique,

- la figure 10 est une représentation schématique d'un premier circuit implémentant les neurones du circuit neuromorphique à base de mémoires vives statiques selon un deuxième document de l'état de la technique,

- la figure 11 est une représentation schématique du circuit électronique en transposant directement le circuit de la figure 9 pour le cas d'une cellule de mémoire résistive,

- la figure 12 est une représentation schématique d'une implémentation concrète d'une première partie neurone de la figure 4,

- la figure 13 est une représentation schématique d'un inverseur en technologie MOS,

- la figure 14 est une représentation schématique d'un premier exemple d'inverseur réalisé à partir d'une cellule RRAM,

- la figure 15 est une représentation schématique d'un deuxième exemple d'inverseur réalisé à partir d'une cellule RRAM,

- la figure 16 est une représentation schématique de deux inverseurs en série réalisés à partir de deux cellules RRAM,

- la figure 17 est une représentation schématique de la mise en oeuvre d'une première étape d'un procédé permettant de passer de cellules RRAM non formées aux deux inverseurs de la figure 16,
- la figure 18 est une représentation schématique de la mise en oeuvre d'une deuxième étape d'un procédé permettant de passer de cellules RRAM non formées aux deux inverseurs de la figure 16,
- la figure 19 est une représentation schématique de la mise en oeuvre d'une troisième étape d'un procédé permettant de passer de cellules RRAM non formées aux deux inverseurs de la figure 16,
- la figure 20 est une représentation schématique d'une implémentation concrète de l'ensemble du neurone de la figure 4,
- la figure 21 est une représentation schématique de l'implémentation de la figure 20 dans une configuration d'effacement,
- la figure 22 est une représentation schématique d'un exemple d'implémentation du circuit neuromorphique avec des calculs effectués en parallèle,
- la figure 23 est une représentation schématique d'un autre exemple d'implémentation du circuit neuromorphique avec des calculs effectués en parallèle,
- la figure 24 est une représentation schématique d'encore un autre exemple d'implémentation du circuit neuromorphique avec des calculs effectués en parallèle,
- la figure 25 est une représentation schématique d'un autre exemple de circuit neuromorphique,
- la figure 26 est une représentation schématique d'un schéma électrique équivalent d'une partie du circuit neuromorphique de la figure 25,
- la figure 27 est une représentation schématique d'un schéma électrique équivalent d'une autre partie du circuit neuromorphique de la figure 25,
- la figure 28 est un graphe présentant les différentes configurations possibles des deux parties représentées des figures 26 et 27, et
- la figure 29 est une représentation schématique d'encore un autre exemple de circuit neuromorphique,
- la figure 30 est une représentation schématique d'un autre exemple de circuit neuromorphique,
- la figure 31 est une représentation schématique d'encore un autre exemple de circuit neuromorphique,
- les figures 32 à 34 sont une représentation schématique du fonctionnement d'encore un autre exemple de circuit neuromorphique,
- la figure 35 est une représentation schématique d'une partie d'un circuit neuromorphique pour des entrées à un bit, et
- les figures 36 à 38 sont une représentation schématique d'une partie d'un circuit neuromorphique pour des entrées à plusieurs bits.

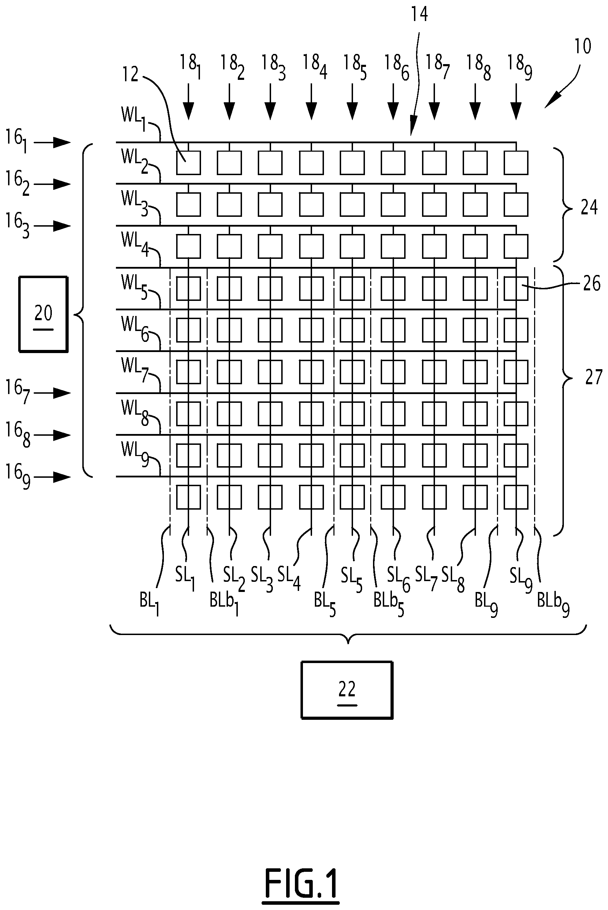

Un circuit neuromorphique 10 propre à mettre en oeuvre un réseau de neurones est représenté sur la figure 1.

Le circuit neuromorphique 10 réalise ici un réseau de neurones de type binaire, c'est-à-dire comme expliqué précédemment un réseau pour lequel les poids synaptiques et les neurones sont binaires.

Le circuit neuromorphique 10 comporte une pluralité de cellules élémentaires 12.

Les cellules élémentaires 12 sont organisées selon une matrice 14 bidimensionnelle comportant des lignes 16 et des colonnes 18.

La matrice sera désignée sous le terme de matrice de cellules 14 dans la suite de la description.

Une cellule élémentaire 12 a les coordonnées (i,j) lorsque ladite cellule élémentaire 12 est positionnée au croisement de la i-ième ligne $16_i$ et de la j-ième colonne $18_j$ avec i et j deux entiers.

Dans le cas de la figure 1, le nombre de lignes 16 et de colonnes 18 est égal à N, de sorte que les indices i et j sont compris au sens large entre 1 et N.

Dans le cas de la figure 1, il a été représenté une matrice de cellule 14 pour laquelle N est égal à 9.

Toutefois, en variante, le nombre de lignes 16 et de colonnes 18 peut être différent.

Le circuit neuromorphique 10 comprend également des lignes de mot WL, des paires de lignes de bits complémentaires BL et BLb, des lignes de source SL et deux contrôleurs 20 et 22.

Dans les notations précédentes, une ligne de mot est référencée WL, le sigle WL renvoyant à la dénomination anglaise correspondante de « *word line* » ; les lignes de bits complémentaires BL et BLb utilisent le sigle BL qui renvoie à la dénomination anglaise correspondante de « *bit line* » et les lignes de source sont référencées avec le sigle SL qui renvoie à la dénomination anglaise correspondante de « *source line* ».

Dans l'exemple de la figure 1, chaque cellule élémentaire est connectée à une ligne de mot WL respective, une ligne de source SL respective et une paire respective de lignes de bits complémentaires BL et BLb.

Chaque cellule élémentaire 12 d'une même ligne 14 partage la même ligne de mot WL, de sorte que les lignes de mot WL peuvent également être indexées avec l'indice i. Ainsi, la première ligne de mot, c'est-à-dire celle qui relie les cellules élémentaires 12 de la première ligne 16, pourra être référencée $WL_1$.

Les cellules élémentaires 12 d'une même colonne 18 partagent la même paire de lignes de bits complémentaires BL et BLb et la même ligne de source SL. Ces trois lignes peuvent donc également être indexées avec l'indice j.

Dans un souci de clarté, l'ensemble des lignes de source SL sont représentées mais seules les paires de lignes de bits complémentaires BL et BLb de la première colonne $18_1$, de la cinquième colonne $18_5$ et de la neuvième colonne $18_9$ sont représentées en traits mixtes sur la figure 1.

Le premier contrôleur 20 est propre à contrôler chaque ligne de mot WL tandis que le deuxième contrôleur 22 est propre à contrôler les paires de lignes de bits complémentaires BL et BLb et les lignes de source SL.

Le premier contrôleur 20 et le deuxième contrôleur 22 sont configurés pour être pilotés de manière coordonnée pour commander les cellules élémentaires 12 à l'aide des lignes qu'ils contrôlent selon le fonctionnement souhaité.

En particulier, le deuxième contrôleur 22 pourra amener les données d'entrées circulant sur chacune des paires de lignes de bits complémentaires BL et BLb. Ce sont ces données d'entrées qui viendront alimenter le réseau de neurones réalisé par le circuit neuromorphique 10.

Dans l'exemple décrit, les cellules élémentaires 12 des trois premières lignes $16_1$, $16_2$ et $16_3$ sont utilisées pour réaliser un neurone du réseau de neurones. Ces cellules élémentaires 12 font donc partie d'un circuit électronique implémentant un neurone 24. Par abus de langage et pour simplifier la description qui va suivre, un tel circuit électronique est simplement dénommé neurone 24.

Les cellules élémentaires 12 des trois premières lignes $16_1$, $16_2$ et $16_3$ seront décrites ultérieurement lorsque le neurone 24 sera décrit.

Les cellules élémentaires 12 des autres lignes $16_4$ à $16_N$ sont associées chacune à un poids binaire respectif du réseau de neurones.

Les cellules élémentaires 12 de ces lignes $16_4$ à $16_N$ servent à mémoriser les poids du réseau de neurones.

De ce fait, dans la suite, ces cellules élémentaires 12 de ces lignes $16_4$ à $16_N$ sont dénommées cellules mémoires 26 et forment un ensemble de mémorisation 27.

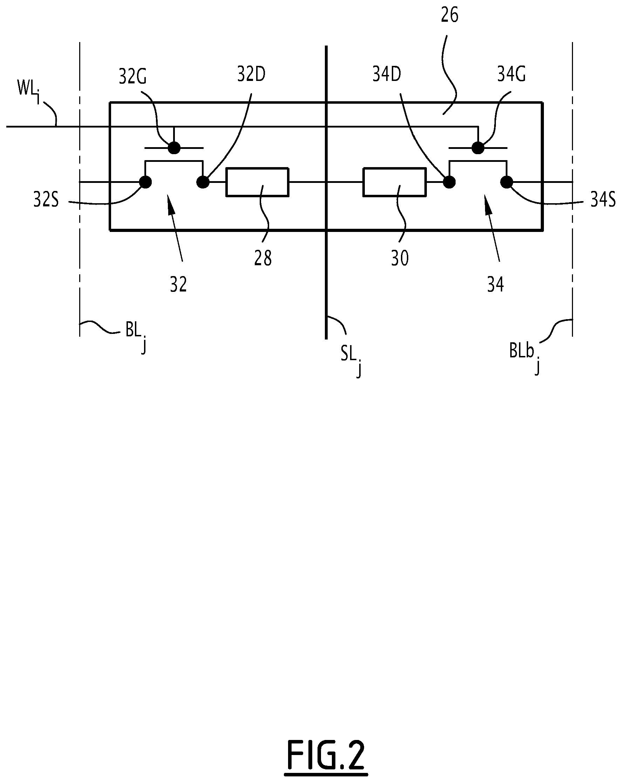

La structure d'une cellule mémoire 26 dans l'environnement des lignes est représentée plus précisément sur la figure 2 pour le cas de la cellule mémoire 26 ayant les coordonnées (i,j).

Chaque cellule mémoire 26 comporte deux memristors, à savoir un premier memristor 28 et un deuxième memristor 30, ainsi que deux commutateurs, un premier commutateur 32 et un deuxième commutateur 34.

Du fait que des memristors 28 et 30 sont présents, une telle cellule mémoire 26 est une cellule de mémoire résistive à accès aléatoire. La cellule mémoire 26 est plus souvent désigné par l'acronyme RRAM ou ReRAM qui renvoie à la dénomination anglaise correspondante de « *Resistive random-access memory* ».

En outre, un tel agencement est généralement appelé structure 2T2R en référence à la présence des deux commutateurs (appellation 2T) et de deux memristors (appellation 2R). La cellule mémoire 26 est parfois dénommée cellule 2T2R.

Un memristor est un composant dont la valeur de sa résistance électrique change, de façon permanente, lorsqu'un courant est appliqué. Ainsi, une donnée peut être enregistrée et réécrite par un courant de contrôle. Un tel comportement est notamment observé dans les matériaux à changement de phase, les jonctions tunnel ferroélectriques ou les mémoires redox à base d'oxydes tels que le $HfO_x$ ou $TiO_{2-x}$.

Le changement de conductance d'un memristor dépend de l'amplitude et de la durée des impulsions de tension appliquées à travers le memristor ainsi que de la valeur maximale de courant pouvant passer dans le memristor par exemple pour une opération de « SET », c'est-à-dire le passage d'une résistance forte à une résistance faible.

Un memristor peut ainsi présenter deux états, un état haut et un état bas.

L'état haut correspond à une forte résistance et est généralement désigné par l'abréviation HRS renvoyant au terme anglais de « *High Resistive State* » qui signifie littéralement état fortement résistif. L'état haut est, de ce fait, dénommé état haut HRS dans la suite.

L'état bas correspond à une faible résistance et est généralement désigné par l'abréviation LRS renvoyant au terme anglais de « *Low Resistive State* » qui signifie littéralement état faiblement résistif. L'état bas est, de ce fait, dénommé état bas LRS dans la suite.

Toutefois, du fait de la variabilité des memristors en fonctionnement, il se trouve que la résistance dans l'état haut HRS peut être inférieure à la résistance dans l'état bas LRS, ce qui génère des erreurs si l'information (poids) est codée dans un seul memristor.

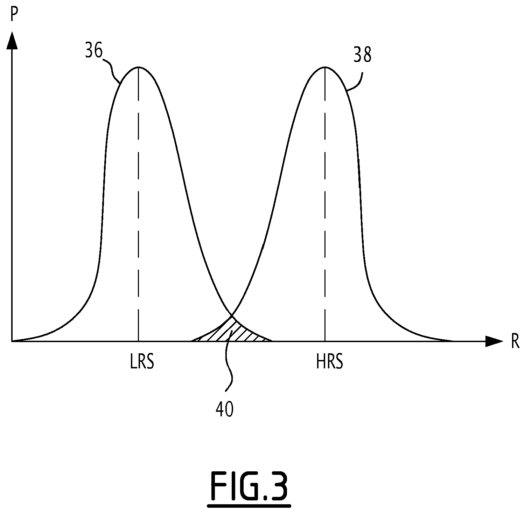

Cette variabilité est présentée schématiquement sur la figure 3. Dans cette figure, il est proposé la probabilité qu'un memristor présente en pratique la valeur de résistance en fonction de l'état du memristor.

Plus précisément, la première courbe, la courbe notée 36, représente schématiquement la probabilité pour l'ensemble des valeurs observées en pratique pour l'état bas LRS tandis que la deuxième courbe 38 représente la même courbe pour l'état haut HRS.

Le graphe de la figure 3 montre bien qu'il existe une zone de recouvrement 40. Dans cette zone de recouvrement 40, distinguer les états bas LRS et haut HRS peut être impossible.

Ce recouvrement peut être plus important avec les dérives temporelles à long terme des memristors.

Pour remédier à ce problème, dans le présent exemple, l'information est codée par le rapport entre les deux résistances des deux états grâce à une configuration en différentiel des deux memristors 28 et 30.

Aussi, selon l'exemple décrit, les memristors 28 et 30 sont des memristors en série et complémentaires respectant le même codage logique.

Par complémentaire, il est ici entendu que les memristors 28 et 30 présentent un état différent, un état bas LRS pour l'un et un état haut HRS pour l'autre.

Selon l'exemple de la figure 2, un poids fort, c'est-à-dire un « 1 » logique, est représenté par un état haut HRS du premier memristor 28 (respectivement un état bas LRS du deuxième memristors 30) tandis qu'un poids faible, c'est-à-dire un « 0 » logique, est représenté par un état bas LRS du premier memristor 28 (respectivement un état haut HRS du deuxième memristors 30).

Dans l'exemple décrit, chacun des deux memristors 28 et 30 est relié à la ligne de source SL commune.

Chacun des deux commutateurs 32 et 34 est par exemple un transistor et plus spécifiquement un transistor à effet de champ.

Un transistor à effet de champ est souvent désigné par l'abréviation FET qui correspond à la dénomination anglaise de « *Field-Effect Transistor »*.

Selon l'exemple décrit, les deux commutateurs 32 et 34 sont des transistors à effet de champ à grille isolée. Un tel transistor est plus souvent désigné sous l'acronyme MOSFET renvoyant à la dénomination anglaise de *« Metal Oxide Semiconductor Field Effect Transistor »*.

Ainsi, chaque commutateur 32 et 34 présente trois électrodes, une grille G, une source S et un drain D.

De manière générale, pour un transistor dont le signe de référence est X, les électrodes seront notées sur les figures selon la notation suivante : la grille XG, la source XS et le drain XD.

Cette notation est choisie ici pour simplifier la représentation, sachant que les positions de la source XS et du drain XD sont définies par rapport au sens de polarisation principal, c'est-à-dire le plus usité pour le montage. Bien entendu, si la polarisation est inversée, l'homme du métier sait que les rôles et les positions de la source XS et du drain XD sont échangés.

Chaque grille 32G et 34G des deux commutateurs 32 et 34 est connectée à la ligne de mot WL. Selon le niveau de tension présent sur la ligne de mot, les commutateurs 32 et 34 sont rendus passants ou au contraire non passants. Le premier contrôleur 20 va en pratique choisir de sélectionner une ligne de cellules en rendant conducteurs les commutateurs des cellules mémoires de cette ligne.

La source 32S du premier commutateur 32 est reliée à la ligne de bit BL tandis que la source 34S du deuxième commutateur 34 est reliée à la ligne de bit complémentaire BLb.

Le drain 32D du premier commutateur 32 est relié à une borne du premier memristor 28, l'autre borne du premier memristor 28 étant reliée à la ligne de source SL commune.

Le drain 34D du deuxième commutateur 34 est relié à une borne du deuxième memristor 30, l'autre borne du deuxième memristor 30 étant reliée à la ligne de source SL commune.

Le second contrôleur 22 va piloter l'alimentation des paires de lignes de bits, de sorte à ce que la tension présentée sur une ligne de bit $BL_i$ soit différente et complémentaire de la tension présentée sur la ligne de bits complémentaire $BL_j$. Ainsi, quand une cellule de coordonnée i,j est sélectionnée (ses commutateurs étant rendus passant par la tension d'activation présentée sur la ligne de mot $WL_i$ associée), les memristors 28 et 30 de cette cellule sont en série et constituent un pont résistif entre les lignes de bit $BL_j$ et $BLb_j$.

Dans le cas d'espèce, les memristors 28 et 30 sont ainsi alimentés par des tensions présentes sur les lignes de bit $BL_j$ et $BLb_j$ symétriques par rapport à une tension par exemple $\frac{V_{dd}}{2}$, dite tension milieu. Dans cette notation, $V_{dd}$ correspond à un potentiel d'alimentation $V_{dd}$. En outre, la masse est notée indifféremment GND ou gnd dans la suite. Bien entendu, il pourrait être choisi une autre tension milieu comme, par exemple, une tension de $\frac{V_{dd}}{3}$.

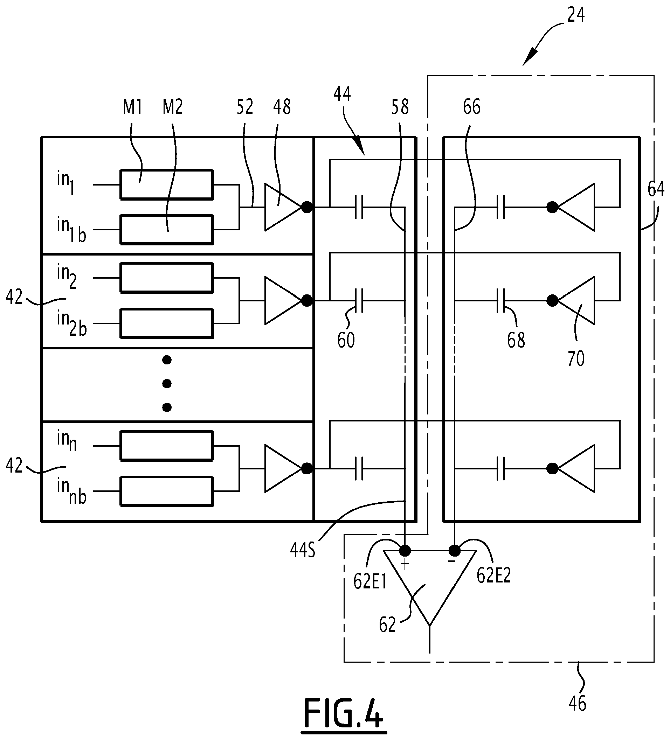

Le neurone 24, c'est-à-dire le circuit électronique l'implémentant est maintenant décrit en référence aux figures 4 à 8.

Pour bien comprendre ce qui va suivre, il peut être observé qu'un réseau de neurones binaire présente une spécificité dans l'inférence par rapport à un réseau de neurones classique.

Quand un réseau de neurones classique est appliqué sur un vecteur d'entrée pour calculer un vecteur de sortie, chaque neurone reçoit des valeurs d'entrée correspondant à des valeurs de sortie des neurones d'une couche précédente $a_j$ et réalise une somme pondérée $\Sigma_j W_{ij} \cdot a_j$ et le neurone applique ensuite une fonction non-linéaire *f* au résultat de la somme pondérée.

Par contraste, dans un réseau de neurones binaire, la somme pondérée est obtenue en réalisant l'opération suivante :

$$a_i = sign\left[popcount_j\left(XNOR(W_{ij}, a_j)\right) - T_i\right]$$

Où :

- $a_i$ et $a_j$ représentent les valeurs de sortie calculées par les neurones de la couche actuelle, respectivement par la couche précédente ;
- $W_{ij}$ représente les poids binaires respectifs pour les neurones de la couche actuelle ;
- *XNOR* est la fonction logique donnant le complément de la fonction OU exclusive (cette fonction est parfois dénommée NON-OU exclusif de ce fait) ;
- *popcount* est la fonction qui compte le nombre de 1 dans une série de bits ;
- $T_i$ est un seuil prédéfini, et
- *sign* est une fonction associant la valeur 1 à une entrée positive et associant - 1 à une valeur négative.

Cela signifie que, dans le cas d'un réseau binaire, il est possible de réaliser physiquement le neurone 24 comme représenté sur la figure 4, à savoir que le neurone 24 comporte des composants XNOR 42, une unité de comptage 44 et une unité de comparaison 46.

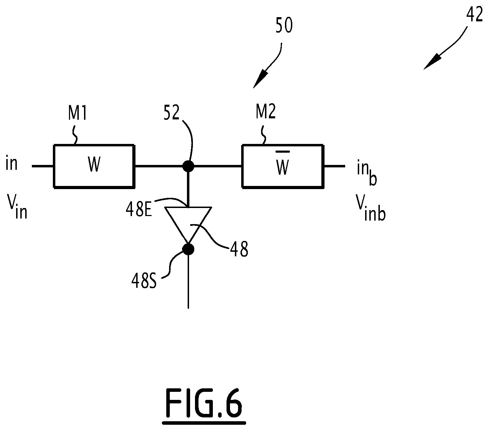

Pour bien comprendre le fonctionnement du neurone 24, il est d'abord expliqué le fonctionnement d'un seul composant XNOR 42 en référence à la figure 6.

Le composant XNOR 42 réalise une opération XNOR sur deux signaux, à savoir un poids noté W et un signal d'entrée noté in.

En l'espèce, le composant XNOR 42 comporte deux memristors M1 et M2 et un inverseur 48.

Les deux memristors M1 et M2 sont des memristors complémentaires connectés en série correspondant au poids W.

Aussi, similairement à ce qui a été décrit précédemment, selon l'exemple de la figure 6, un « 1 » logique est représenté par un état haut HRS du memristor M1 (l'autre memristor M2 étant dans l'état bas LRS) tandis qu'un « 0 » logique est représenté par un état bas LRS du memristor M1 (l'autre memristor M2 étant dans l'état haut HRS).

Les memristors M1 et M2 sont reliés à une extrémité à l'inverseur 48 et à l'autre extrémité à une tension respective.

On notera la première tension $V_{in}$ et la deuxième tension $V_{inb}$.

La configuration électrique est donc celle d'un pont diviseur de tension 50 relié d'une part à la première tension $V_{in}$ et d'autre part à la deuxième tension $V_{inb}$ et dont le point milieu 52 est relié à l'entrée de l'inverseur 48. Autrement formulé, l'un des memristors M1 est soumis à une tension $|V_{in} - V_{mid}|$ et l'autre memristor M2 est soumis à une tension $|V_{mid} - V_{inb}|$. La notation $V_{mid}$ désigne la tension du point milieu 52 du pont diviseur 50.

Ainsi, dans le cas décrit, le signal d'entrée in correspond à la paire de la première tension $V_{in}$ et de la deuxième tension $V_{inb}$.

Ces tensions $V_{in}$ et $V_{inb}$ ont la particularité d'être symétriques par rapport à la moitié du potentiel d'alimentation $\frac{VDD}{2}$. En pratique, on pourra avantageusement choisir d'avoir Vin égale à Vdd ou gnd, et respectivement Vinb égale à gnd ou Vdd.

Dans l'exemple décrit, le signal d'entrée in code pour un « 1 » logique lorsque la première tension $V_{in}$ est strictement supérieure à la deuxième tension $V_{inb}$, c'est-à-dire que $V_{in} > V_{inb}$.

Réciproquement, le signal d'entrée in code pour un « 0 » logique lorsque la première tension $V_{in}$ est strictement inférieure à la deuxième tension $V_{inb}$, c'est-à-dire que $V_{in} < V_{inb}$.

Cette représentation schématique de deux memresistors M1, M2 en série entre deux tensions Vin et Vinb correspond en pratique au circuit équivalent formé par une cellule 26 sélectionnée (la ligne de mot WL associée présente une tension rendant ses commutateurs passants) et recevant via les lignes de bit BL et BLb des tensions de polarisation correspondant à Vin et Vinb. Autrement dit, le signal d'entrée in est amené à une cellule sélectionnée via les lignes de bit BL et BLb associées par l'action du contrôleur 22. Le point milieu 52 du pont diviseur correspond alors à la ligne de source SL connectée à la cellule considérée.

L'inverseur 48 est un élément propre à recevoir un signal incident sur une entrée 48E et effectuer un calcul d'inversion logique pour émettre sur une sortie 48S un signal de sortie qui est l'inverse du signal incident.

Ici, l'entrée 48E de l'inverseur 48 est connectée au point milieu 52 du pont diviseur 50 formé par les deux memristors M1 et M2.

La sortie 48S de l'inverseur 48 donne le résultat de l'opération XNOR appliquée au signal d'entrée in et au poids W.

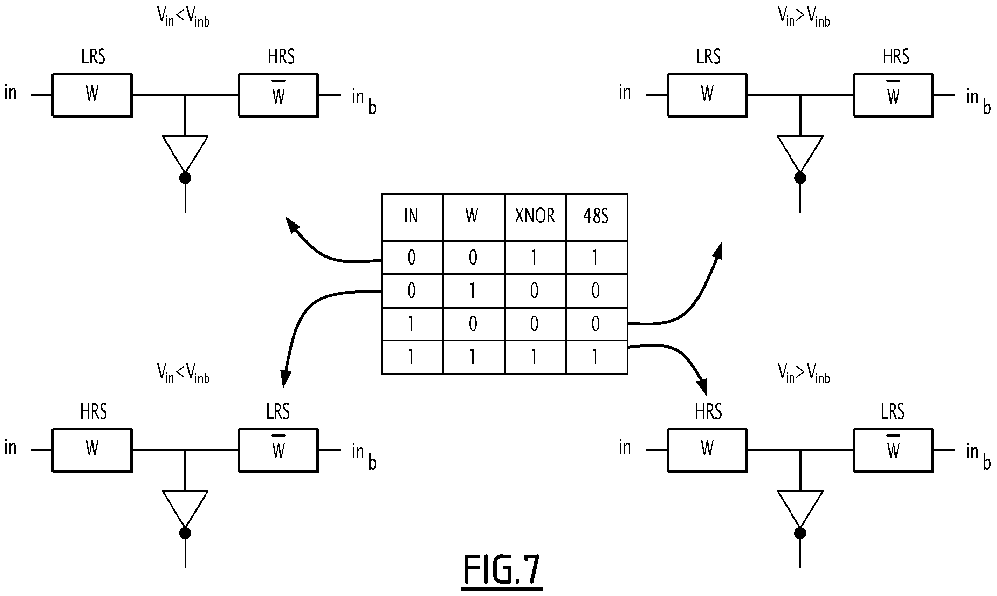

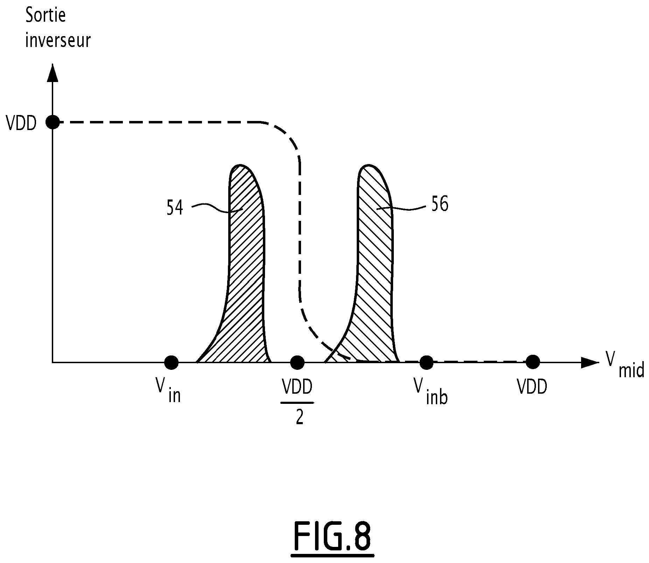

Le fonctionnement du composant XNOR 42 est maintenant décrit en référence aux figures 7 et 8 qui représentent schématiquement respectivement les quatre cas possibles de fonctionnement du composant XNOR 42 et la valeur des tensions en sortie pour deux des quatre cas possibles. Dans cette figure, les signes de référence ne sont pas repris pour ne pas alourdir trop ces figures.

Plus précisément, le cas en haut à gauche de la figure 7 correspond au cas où le signal d'entrée in vaut 0 et la valeur du poids W est égal à 0.

Dans un tel cas, comme expliqué précédemment, la première tension $V_{in}$ est strictement inférieure à la deuxième tension $V_{inb}$, c'est-à-dire que $V_{in} < V_{inb}$ (avec par exemple $V_{in}$ = gnd et $V_{inb}$ = Vdd).

En outre, le premier memristor M1 est dans l'état bas LRS alors que le deuxième memristor M2 est dans l'état haut HRS.

Du fait de la configuration, le memristor dans l'état haut HRS absorbe la quasi-totalité de la dynamique de tension, repoussant la tension $V_{mid}$ du point milieu 52 vers la tension à l'extrémité du memristor dans l'état bas LRS.

En l'occurrence, cela signifie que la tension $V_{mid}$ du point milieu 52 est repoussée vers la première tension Vin comme représenté schématiquement par la courbe 54 sur la figure 8.

Comme apparent sur cette figure 8, la tension du point milieu $V_{mid}$ est distinctement au-dessous de la moitié du potentiel d'alimentation $\frac{VDD}{2}$.

La sortie out de l'inverseur 48 est alors à 1.

Cela montre que pour un signal in à 0 et pour un poids à 0, la sortie de l'inverseur 48 est alors à 1, ce qui correspond bien à XNOR(0,0) = 1.

Le cas en bas à droite de la figure 7 correspond au cas correspondant dans lequel le signal d'entrée in vaut 0 et la valeur du poids W est égal à 1.

Dans un tel cas, par rapport au cas précédent, la seule différence est que le premier memristor M1 est dans l'état haut HRS alors que le deuxième memristor M2 est dans l'état bas LRS.

Il en résulte que la tension du point milieu $V_{mid}$ est repoussée vers la deuxième tension $V_{inb}$ comme représenté schématiquement par la courbe 56 sur la figure 8.

La sortie out de l'inverseur 48 est alors à 0.

Cela montre que pour un signal in à 0 et pour un poids à 1, la sortie de l'inverseur 48 est alors à 1, ce qui correspond bien à XNOR(0,1) = 0.

Les mêmes remarques s'appliquent pour les cas à droite sur la figure 7.

Le cas du haut correspond un signal d'entrée in valant 1 ($V_{in} > V_{inb}$, avec par exemple $V_{in}$ = Vdd et $V_{inb}$ = Gnd) et un poids valant 0 (premier memristor M1 dans l'état bas LRS et deuxième memristor M2 dans l'état haut HRS) de sorte que la tension du point milieu $V_{mid}$ est repoussée vers la première tension $V_{in}$, c'est-à-dire que $V_{mid} > \frac{VDD}{2}$. Il en résulte que la sortie out de l'inverseur 48 est à 0. Cela correspond bien à réaliser l'opération XNOR(1,0) = 0.

Le cas du bas correspond à un signal d'entrée in valant 1 ($V_{in} > V_{inb}$) et un poids valant 1 (premier memristor M1 dans l'état haut HRS et deuxième memristor M2 dans l'état bas LRS) de sorte que la tension du point milieu $V_{mid}$ est repoussée vers la deuxième tension $V_{inb}$, c'est-à-dire que $V_{mid} < \frac{VDD}{2}$. Il en résulte que la sortie out de l'inverseur 48 est à 1. Cela correspond bien à réaliser l'opération XNOR(1,1) = 1.

Les différents cas décrits conduisent bien à obtenir la table de vérité visible sur la figure 7, qui illustre bien que la sortie out de l'inverseur réalise une opération XNOR.

Un tel composant XNOR 42 permet d'obtenir une sortie en tension qui ne présente pas la variabilité de résistance des memristors M1 et M2.

La réduction de la variabilité provient de deux éléments complémentaires.

Une première réduction de la variabilité est obtenue par utilisation du montage en différentiel des deux memristors M1 et M2. Néanmoins, au niveau du point milieu 52 du pont diviseur 50, le signal est encore sujet aux variabilités des memristors M1 et M2. De fait, la tension du point milieu dépend du ratio entre les valeurs des résistances des memristors M1 et M2, ce qui diminue la variabilité mais pas complètement.

La deuxième réduction de variabilité est obtenue avec l'emploi de l'inverseur 48 comme cela apparaît en référence à la figure 8.

Il en résulte que le signal en sortie de l'inverseur 48 n'est pas sensible aux variations de résistance des memristors.

Selon l'exemple de la figure 4, l'unité de comptage 44 est formée par un pont capacitif 58.

Comme indiqué précédemment, l'unité de comptage 44 est propre à compter le nombre de 1 dans une série de bits, c'est-à-dire à mettre en oeuvre une opération de popcount.

Un pont capacitif 58 est un ensemble de condensateurs 60 reliés en parallèle et reliés entre eux sur une de leurs bornes.

En outre, selon l'exemple décrit, chaque condensateur 60 présente la même valeur de capacité.

Chaque condensateur 60 est relié à un composant XNOR 42 qui lui est propre.

De ce fait, la tension en sortie de l'unité de comptage 44 est proportionnelle au nombre de 1 en sortie des composants XNOR 42.

La sortie 44S de l'unité de comptage 44 est reliée à l'unité de comparaison 46 qui sert à comparer une tension incidente à une tension de comparaison.

Plus précisément, l'unité de comparaison 46 comporte deux éléments : un comparateur 62 et un générateur de tension de comparaison 64. La sortie de l'unité de comptage 44 est ainsi reliée à une entrée 62E1 du comparateur 62, l'autre entrée 62E2 du comparateur 62 étant relié au générateur de tension de comparaison 64.

Selon l'exemple décrit, le générateur de tension de comparaison 64 est un deuxième pont capacitif 66 dont les entrées sont les inverses des composants XNOR 42 du premier pont capacitif 58.

Pour cela, chaque condensateur 68 du deuxième pont capacitif 66 est relié à un inverseur 70 lui-même relié à un composant XNOR 42 respectif.

Le générateur de tension de comparaison 64 génère ainsi une tension proportionnelle au nombre de 0 en sortie des composants XNOR 42.

Le comparateur 62 compare ensuite les deux tensions provenant des deux ponts capacitifs 58 et 66, c'est-à-dire ici le nombre de 1 en sortie des composants XNOR 42 et le nombre de 0 en sortie des composants XNOR 42.

Le comparateur 62 génère un « 1 » en sortie si nombre de 1 est supérieur au nombre de 0 et « 0 » dans le cas contraire.

La sortie du comparateur 62 correspond à la sortie du neurone 24.

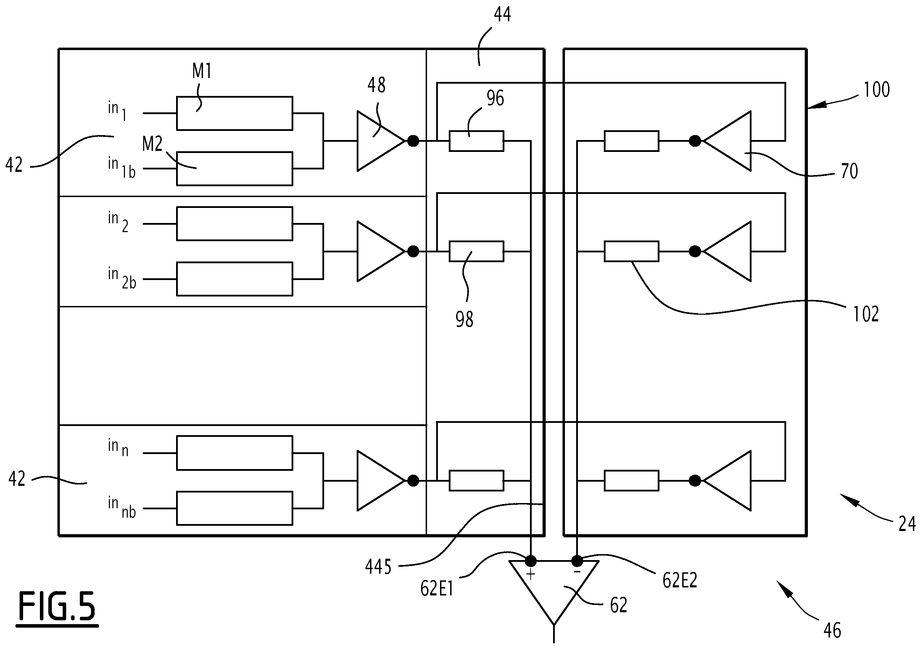

Selon un autre exemple illustré par la figure 5, l'unité de comptage 44 est formée par un pont résistif 96 à N résistances 98 au lieu d'un pont capacitif.

En outre, dans ce cas de la figure 5, le générateur de tension de comparaison 46 est également un pont résistif 100 comportant également N résistances 102.

Ainsi, le fonctionnement est similaire à celui décrit pour le pont capacitif 56. Plus, précisément, il est ainsi obtenu un pont résistif 96 où un certain nombre x de résistances 98 sont soumises au potentiel d'alimentation VDD (ce qui correspond à une sortie à 1 pour le composant XNOR associé), les N-x autres résistances 98 étant soumises à la masse GND (ce qui correspond à une sortie à 0 pour le composant XNOR 42 associé). La tension obtenue est ainsi une image du ratio entre le nombre de composant XNOR 42 à la valeur 1 et le nombre de composant XNOR à la valeur 0.

Cette approche a l'avantage de fonctionner avec toutes les mémoires résistives, mêmes celles qui ne peuvent pas fonctionner en mode capacitif.

En variante, le générateur de tension de comparaison 64 est un générateur générant une tension de référence fixe. Typiquement, le générateur de tension de comparaison 64 pourra générer une tension correspondant à la moitié du potentiel d'alimentation, à savoir

$$\frac{VDD}{2}.$$

Dans une telle variante, Le comparateur 62 génère comme valeur de sortie du neurone un « 1 » si le nombre de 1 en sortie des comparaisons XNOR 42 correspond à une tension supérieure à la tension de référence. A défaut, le comparateur 62 génère comme valeur de sortie du neurone un « 0 ». A ce stade, il peut être noté que l'utilisation proposée d'un pont capacitif 58 comme unité de comptage 44 dans le cas de cellules RRAM est originale.

De fait, l'emploi de point capacitif pour un tel usage ne se retrouve dans l'état de la technique que dans le cas des mémoires vives statiques ou SRAM (qui vient de la dénomination anglaise correspondante de *« Static Random Access Memory »)* et notamment dans les deux articles suivants :

- un article de D. Bankmann et al. intitulé « An always-on 3.8 mµJ/86 % cifar 10 mixed-signal cnn processor with all memory on chip in 28-nm CMOS » publié en 2018 de la conférence ISSCC (International Solid - State Circuits Conference) organisée par l'IEEECC et
- un article de Hossein Valavi et al. intitulé « A Mixed-Signal Binarized Convolutional-Neural-Network Accelerator Integrating Dense Weight Storage and Multiplication for Reduced Data Movement » publié à l'occasion du symposium sur les circuits VLSI en 2018.

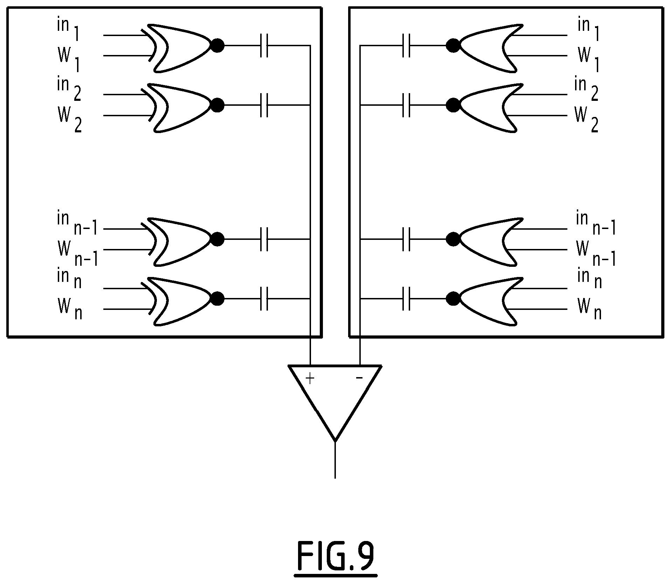

Le premier article propose le montage de la figure 9. Comme précédemment, pour un neurone donné, les multiplications entre les entrées et les poids sont effectués à l'aide de portes XNOR et l'opération de popcount est effectuée à l'aide du pont capacitif : chaque porte XNOR est connectée à une capacité en sa sortie, et l'ensemble des capacités sont ensuite connectées entre elles à leur autre extrémité, formant ainsi le pont capacitif. Pour compter le nombre de '0' en sortie du pont capacitif, un deuxième pont est construit à l'aide de portes XOR cette fois : la tension du deuxième pont est proportionnelle au nombre de '0' en sortie des portes XNOR du premier pont. Ensuite, les tensions des deux ponts sont comparées par un comparateur générant une valeur '1' à la sortie du neurone si la tension du premier pont est supérieure à celle du deuxième pont.

L'application directe de la structure proposée par ce premier article à une mémoire RRAM requiert ainsi de lire les poids en RRAM et les entrées en SRAM ou RRAM pour acheminer chacune de ces valeurs lues vers le neurone capacitif. Cela nécessiterait un routage complexe en périphérie de la mémoire pour acheminer les poids stockés en RRAM et les entrées stockées en SRAM vers les neurones capacitifs. Cela n'est donc pas envisageable ou au moins beaucoup plus complexe que le présent cas.

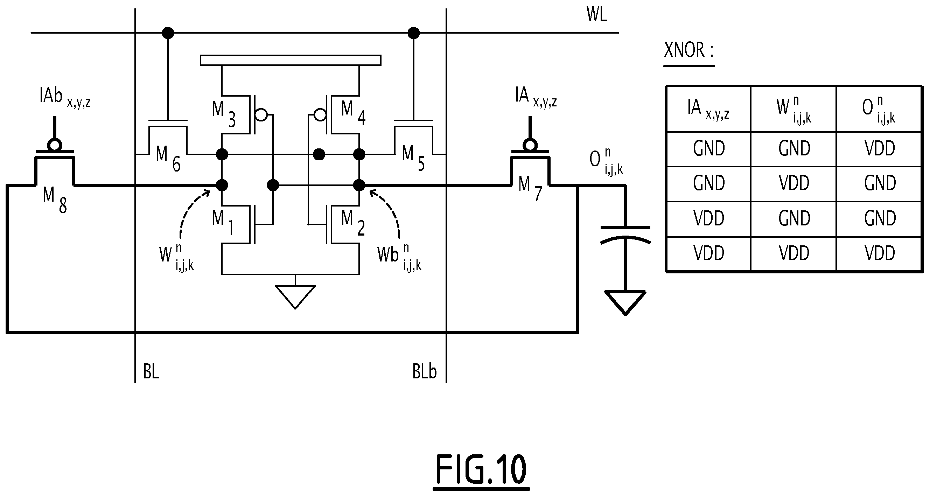

Le deuxième article, celui de Valavi et al., présente la même structure, mais en intégrant l'opération du XNOR et les capacités directement dans les cellules SRAM, gagnant ainsi en terme de bande passante. La figure 10 illustre la structure de la cellule SRAM proposée dans cet article. L'ensemble des circuits en ligne en trait gras permet de calculer une opération XNOR entre une valeur d'entrée et le poids mémorisé dans la cellule SRAM, puis de charger la valeur de l'opération XNOR dans une capacité.

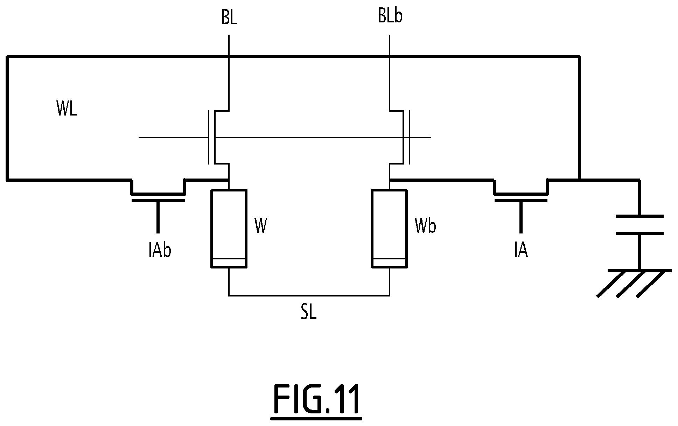

L'application directe de la structure proposée ce deuxième article à une mémoire RRAM permet d'obtenir le montage de la figure 11.

Toutefois, là encore, un tel montage n'est pas satisfaisant. En effet, ce circuit charge la capacité directement via le memristor, ce qui a pour effet de transférer la variabilité du memristor sur la charge de la capacité. De ce fait, le problème reste entier, la variabilité du memristor étant toujours un facteur limitant.

De plus, l'ajout de deux transistors au sein de chaque cellule mémoire augmente la surface globale de la mémoire, de sorte que non seulement la variabilité est toujours gênante mais, en plus, le montage est plus encombrant.

Par contraste, le présent neurone 24 permet de bénéficier des avantages d'un pont capacitif 58 (faible consommation notamment) tout en gérant astucieusement la grande variabilité des memristors comme expliqué précédemment en référence à la figure 8.

En outre, comme représenté sur la figure 1, un tel neurone 24 est réalisable de manière très intégrée puisque le neurone 24 peut être réalisé physiquement sur seulement trois lignes $16_1$, $16_2$ et $16_3$ de la matrice de cellules 14.

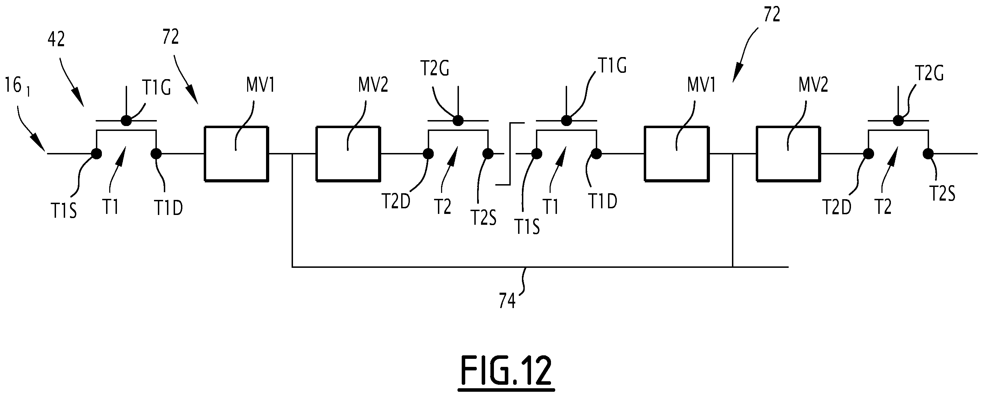

Un exemple d'une telle réalisation intégrée est maintenant décrit en référence aux figures 12 à 17.

La figure 12 représente une réalisation de l'unité de comptage 44 sur la première ligne $16_1$.

La première ligne $16_1$ forme donc le pont capacitif 58.

Avant de décrire la première ligne $16_1$ plus précisément, il convient d'expliquer qu'un memristor présente le fonctionnement de résistance programmable décrit précédemment avec un état bas LRS et un état haut HRS uniquement après une étape de formation.

Une étape de formation consiste à appliquer une relativement forte tension (dite tension de forming) sur le memristor, typiquement une tension comprise entre 3 V et 4V selon les technologies utilisées.

Autrement formulé, avant formation, un memristor est dans un état dit état vierge puis après formation présente le comportement précité avec les états haut HRS et bas LRS.

Dans l'état vierge, le memristor présente un comportement capacitif. Dans la suite, un tel memristor est appelé « memristor vierge » pour le distinguer d'un memristor formé.

La première ligne $16_1$ représentée sur la figure 12 est une ligne de cellules élémentaires 12 dans lesquelles chaque memristor est un memristor vierge MV1 et MV2. Une telle ligne $16_1$ pourrait donc être qualifiée de ligne de cellules capacitives 2T2C en indiquant par « C » chaque memristor vierge MV1 et MV2. Pour clarifier le propos, les cellules élémentaires 14 de la première ligne $16_1$ sont dénommées cellules capacitives 72.

En outre, les deux commutateurs T1 et T2 de chaque cellule capacitive 68 sont connectés entre eux.

Cela permet de mettre les deux memristors vierges MV1 et MV2 d'une même cellule capacitive 72 en parallèle. Il en résulte que la capacité d'une cellule capacitive 72 est deux fois plus grande que la capacité d'un seul memristor vierge MV1 ou MV2.

L'ensemble des cellules capacitives 68 sont reliées à une même ligne de sortie 74.

La ligne de sortie 74 est reliée au point milieu situé entre les deux memristors vierges MV1 et MV2.

Une telle réalisation de l'unité de comptage 44 est avantageuse car elle est basée sur une ligne $16_1$ de cellules mémoires standard prises avant l'étape de formation des memristors. Les seules modifications à apporter sont d'ajouter la ligne de sortie 74 et les connexions de chaque cellule capacitive 72 à cette ligne de sortie 74. Ces modifications se font simplement en modifiant le routage de l'architecture des cellules (plus communément appelée selon la dénomination anglaise correspondante de « layout ») sans aucun changement dans l'architecture elle-même qui est conservée. L'architecture des cellules est plus communément appelée selon la dénomination anglaise correspondante de « layout ». Ici, c'est bien le layout qui est inchangé.

En outre, il sera expliqué ultérieurement qu'un tel agencement permet d'obtenir une procédure d'effacement des memristors vierges MV1 et MV2 qui est relativement simple à mettre en oeuvre.

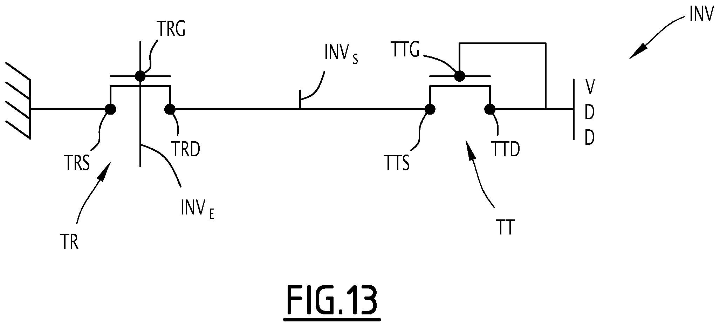

En référence aux figures 13 à 19, il est expliqué comme réaliser la partie inversion du neurone 24 à l'aide des deuxième et troisième lignes $16_2$ et $16_3$ de la matrice de cellules 14.

Avant de détailler l'adaptation de ces deuxième et troisième lignes $16_2$ et $16_3$, il convient de préciser que les cellules mémoire 26 utilisent des commutateurs 32 et 34 qui sont généralement des transistors NMOS, c'est-à-dire des MOSFETs de type n.

En outre, il peut être rappelé qu'un inverseur INV peut être réalisé à partir de transistors comme montré sur la figure 13.

L'inverseur INV comporte deux transistors TR et TT en série branchés, le transistor de gauche TR étant relié à la masse GND et le transistor de droite TT étant relié au potentiel d'alimentation Vdd. En outre, le transistor de droite TT est connecté en diode.

Dans une telle configuration, le transistor de gauche TR est usuellement appelé transistor de rappel ou plus souvent « *pull-down transistor* » en référence à la dénomination anglaise correspondante. Le transistor de droite TT est usuellement appelé transistor de tirage ou plus souvent *« pull-up transistor »*.

L'entrée de l'inverseur INV est la grille du transistor de rappel TR et la sortie de l'inverseur INV est le point milieu des deux transistors TR et TT.

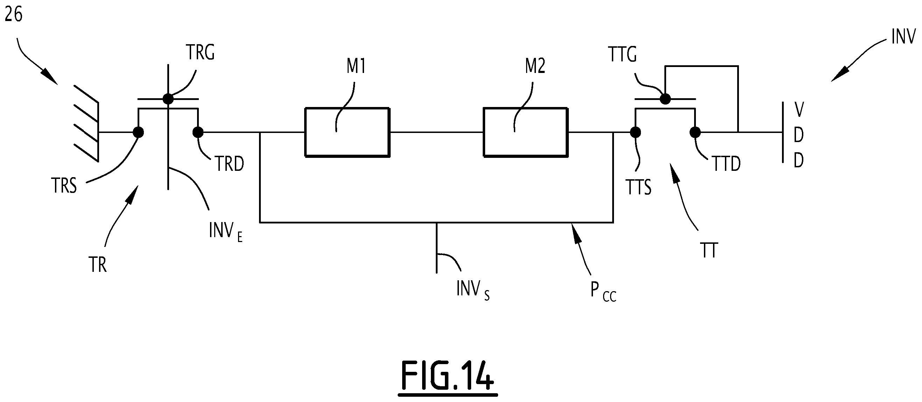

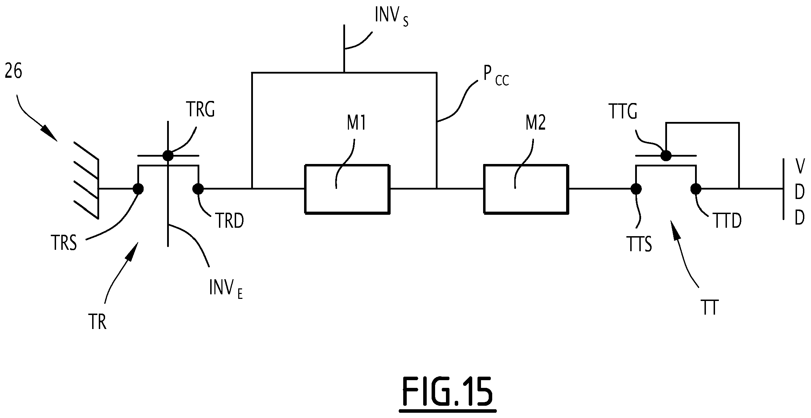

Aussi, pour obtenir un inverseur à partir d'une cellule mémoire 26, deux montages peuvent être envisagés. Le premier montage est illustré sur la figure 14 et le deuxième montage correspond à la figure 15.

Dans le premier montage, les deux memristors M1 et M2 sont court-circuités à l'aide d'une piste de court-circuit $P_{cc}$.

Une telle approche implique de dimensionner le transistor de tirage TT pour être plus résistif que le transistor de rappel TR, pour obtenir un niveau bas de bonne qualité.

Dans le deuxième montage, le transistor de tirage TT est toujours connecté en diode mais la piste de court-circuit $P_{cc}$ est différente. Au lieu d'être connectée pour court-circuiter les deux memristors, la piste de court-circuit $P_{cc}$ est agencée uniquement pour court-circuiter le memristor M1 du transistor de rappel TR. Par ailleurs, le deuxième memristor M2 est placé dans l'état haut HRS.

Dans l'exemple décrit, le deuxième memristor M2 est à placer dans l'état haut HRS car l'électrode supérieure (plus communément appelée « top electrode » en référence à la dénomination anglaise correspondante) est connectée au point milieu de la structure 2T2R. Bien entendu, dans un montage où c'est l'électrode inférieure (« bottom electrode » selon la terminologie anglaise) qui est connectée au point milieu, il conviendrait de placer le deuxième memristor M2 dans l'état bas LRS.

Une telle approche permet d'obtenir un transistor de rappel TR plus résistif sans rendre le transistor de tirage TT connecté en diode plus résistif. Dans un tel montage, il y a uniquement des modifications de connectiques et pas de l'architecture des cellules comme indiqué précédemment.

Ces deux montages peuvent être intégrés dans la matrice de cellules 14 en étant implémenté sur une seule ligne 16 de cellules mémoires 26.

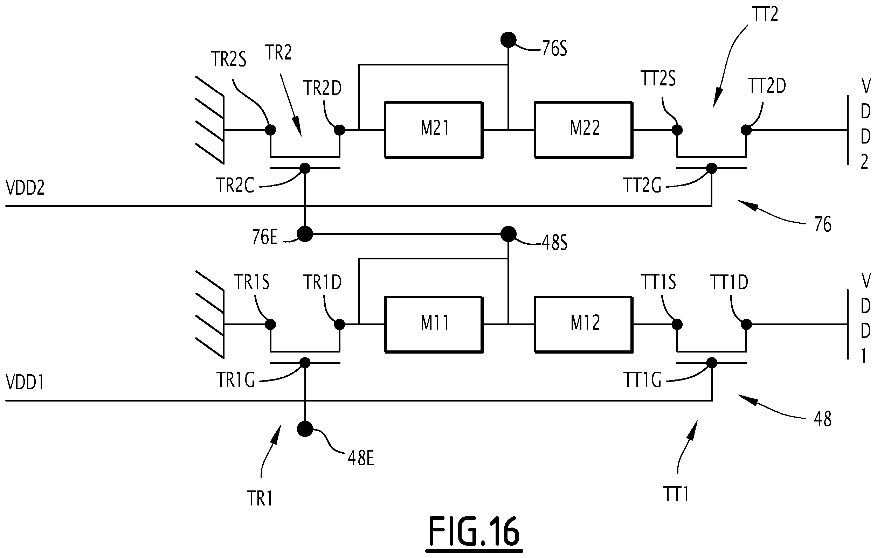

Néanmoins, en référence à la figure 16, il est plus favorable de mettre deux inverseurs 48 et 76 en série comme cela va être expliqué dans ce qui suit.

Le premier inverseur 48 et le deuxième inverseur 76 présentent chacun la structure décrite sur la figure 15, en notant chaque élément avec un « 1 » dans le signe de référence pour le premier inverseur 48 et un « 2 » pour le deuxième inverseur 76.

Avec ces notations, ce sont les premiers memristors M11 et M21 qui sont en court-circuit respectivement dans le premier inverseur 48 et le deuxième inverseur 76.

L'entrée 48E du premier inverseur 48 est destiné à être connectée à une ligne de source et est relié au premier transistor TR1 de cet inverseur.

La sortie 48S du premier inverseur 48 est reliée à l'entrée 76E du deuxième inverseur 76 et par là au premier transistor TR2 du deuxième inverseur 76.

La sortie 76S du deuxième inverseur 76 est destinée à être reliée à l'unité de comptage 44.

Ainsi, dans cette configuration, cela implique que le neurone 24 présente deux inverseurs 48 et 76 en série pour chaque condensateur 60 du pont 58.

Une telle configuration présente plusieurs avantages.

Il convient de noter que l'entrée 48E du premier inverseur 48 permettant de réaliser l'opération XNOR est assez proche de la moitié du potentiel d'alimentation $\frac{VDD}{2}$. Par conséquent, le signal en sortie du premier inverseur 48 n'offre pas forcément deux niveaux « 1 » et « 0 » très distants. La présence du deuxième inverseur 76 permettent de purifier le signal de sortie du premier inverseur 48 avec des niveaux haut et bas très éloignés.

En outre, une telle configuration avec deux inverseurs 48 et 76 permet aussi de conserver les memristors MV1 et MV2 de l'unité de comptage 44 dans leur état vierge. De fait, il convient que la tension aux bornes de ces memristors vierges MV1 et MV2 ne dépassent pas la tension de forming. Avec la configuration proposée à deux inverseurs 44 et 76 en série, le premier inverseur 48 peut être alimenté avec une tension forte pour bien distinguer les niveaux hauts et bas, et le deuxième inverseur 76 peut être alimenté avec une tension suffisamment basse pour ne pas dépasser la tension de forming des memristors vierges MV1 et MV2 de l'unité de comptage 44.

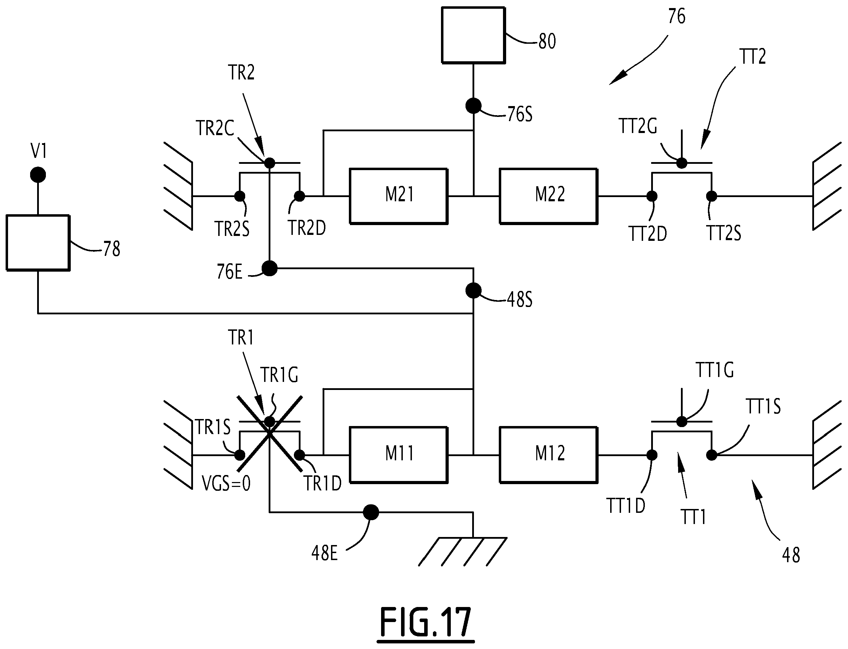

Enfin, une telle configuration peut aisément être réalisée comme cela va être montré en référence aux figures 17 à 19 qui illustrent comment en trois étapes successives, il est possible de passer de deux cellules mémoires avec des memristors vierges à des memristors dans l'état haut HRS. Cette illustration est réalisée également dans le cas où l'électrode supérieure des memristors est connectée au point milieu de la structure 2T2R.

Dans chacune de ces étapes, la ligne de mot WL de l'unité de comptage 44 est mise à la masse GND, la grille des transistors des deux inverseurs 48 et 76 est mise au potentiel d'alimentation VDD et l'entrée 48E du premier inverseur 48 est à la masse GND.

La première étape illustrée par la figure 17 consiste à faire passer le deuxième memristor M12 du premier inverseur 48 de l'état vierge à l'état bas LRS.

Pour cela, la sortie 48S du premier inverseur 48 est connectée à une tension V1 supérieure à la tension de forming en activant un interrupteur 78 relié à une première source de tension et la source TT1S du premier transistor de tirage TT1 est connectée à la masse GND.

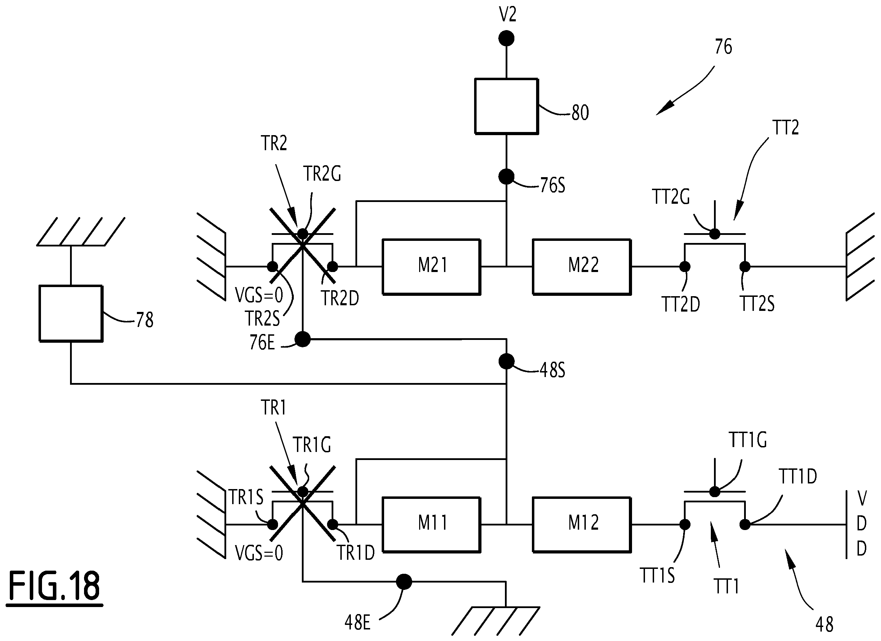

La deuxième étape illustrée par la figure 18 consiste d'une part à faire passer le deuxième memristor M12 du premier inverseur 48 de l'état bas LRS à l'état haut HRS et d'autre part à faire passer le deuxième memristor M22 du deuxième inverseur 76 de l'état vierge à l'état bas LRS.

Pour obtenir le passage de l'état bas LRS à l'état haut HRS, la sortie 48S du premier inverseur 48 est connectée à la masse GND en laissant l'interrupteur 78 activé mais en le connectant à la masse. En parallèle, la source TT1S du premier transistor de tirage TT1 est connectée au potentiel d'alimentation VDD.

Le passage de l'état vierge à l'état bas LRS est quant à lui obtenu en connectant la sortie 76S du deuxième inverseur 76 à une tension V2 supérieure à la tension de forming en activant un interrupteur 80 relié à une deuxième source de tension. En parallèle, la source TT2S du deuxième transistor de tirage TT2 est connectée à la masse GND.

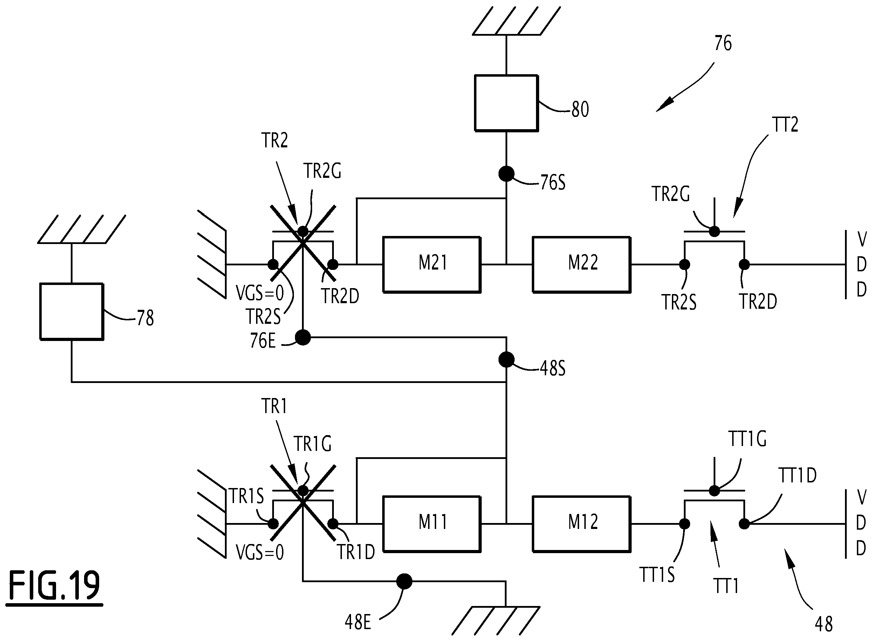

La troisième étape illustrée par la figure 19 consiste à faire passer le deuxième memristor M22 du deuxième inverseur 76 de l'état bas LRS à l'état haut HRS.

Pour cela, la sortie 76S du deuxième inverseur 76 est connectée à la masse GND, et la source TT2S du deuxième transistor de tirage TT2 est connectée au potentiel d'alimentation VDD. En parallèle, les tensions aux bornes du premier inverseur 48 sont les mêmes que lors de la deuxième étape.

Il est ainsi obtenu aisément la configuration de fonctionnement de deux inverseurs 48 et 76 à partir de deux cellules mémoires avec des memristors vierges.

A travers la description des figures 12 à 19, il a été expliqué progressivement comment réaliser le neurone 24 à partir de seulement trois lignes $16_1$, $16_2$ et $16_3$ de la matrice de cellules 14.

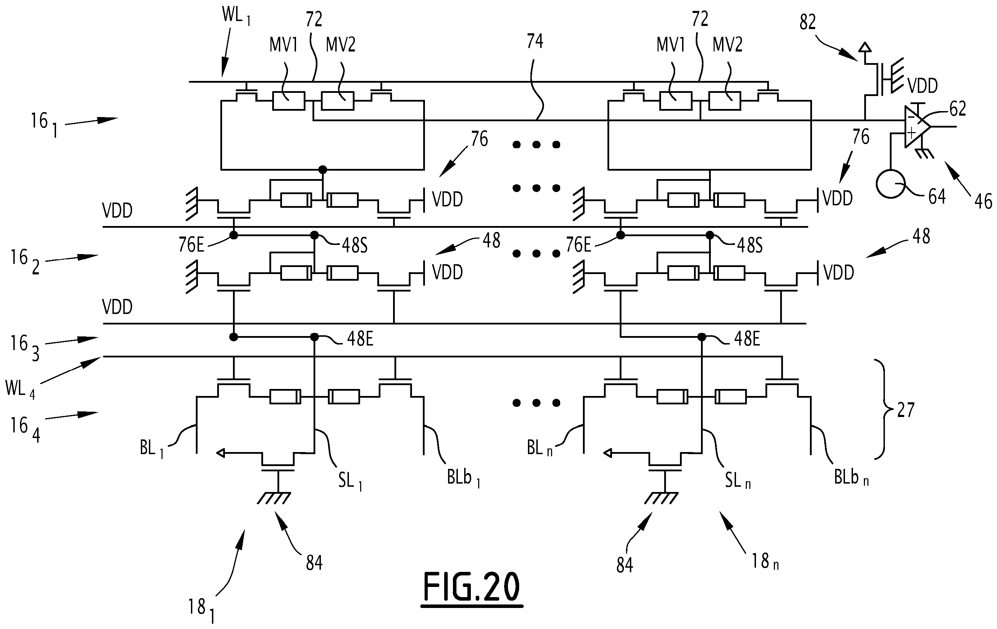

La figure 20 représente le détail des circuits de ces trois lignes $16_1$, $16_2$ et $16_3$ connectées ensemble et connectées à leur environnement immédiat.

Comme expliqué précédemment, la première ligne $16_1$ permet d'obtenir l'unité de comptage 44, la deuxième ligne $16_2$ permet d'obtenir un ensemble de deuxièmes inverseurs 76 et la troisième ligne $16_3$ permet d'obtenir un ensemble de premiers inverseurs 48.

Dans la figure 20, seuls les éléments extrêmes de chaque ligne 16, c'est-à-dire ceux correspondant à la première colonne $18_1$ et la dernière colonne $18_n$ sont représentés.

Comme indiqué précédemment, les autres lignes $16_4$ à $16_N$ servent à stocker les poids du réseau de neurones. Dans la figure 20, seule la quatrième ligne $16_4$ de l'ensemble de mémorisation 27 est représentée dans un souci d'alléger cette figure.

En partant de la quatrième ligne $16_4$ vers la première ligne $16_1$, la description peut être faite.

Les entrées 48E des premiers inverseurs 48 sont connectées à une ligne de source SL respective provenant de la quatrième ligne $16_4$. Dans l'exemple de la figure 20, la première ligne de source $SL_1$ est donc reliée à l'entrée 48E du premier inverseur 48 de gauche et la dernière ligne de source $SL_n$ est reliée à l'entrée 48E du premier inverseur 48 de droite.

En référence à la figure 4 ou 6, cela signifie que les memristors M1 et M2 du composant XNOR 42 sont les memristors 28 et 30 d'une cellule mémoire 26 et que les premières tensions Vin et Vinb sont réalisées par la paire de ligne de bits complémentaires BL et BLb. Comme cela découle de l'explication donnée en lien avec la figure 4, les valeurs des premières tensions complémentaires $V_{in}$ et $V_{inb}$ correspondent ainsi à une valeur de donnée d'entrée du neurone, cette donnée d'entrée étant appliquée sur l'équivalent d'une synapse du neurone réalisée par les éléments de la colonne de la matrice (notamment les memristors 28 et 30 mémorisant les poids synaptiques).

Comme explicité précédemment, les sorties 48S des premiers inverseurs 48 sont reliées aux entrées 76E des deuxièmes inverseurs 76.

Chaque sortie 76S d'un deuxième inverseur 76 est ensuite reliée à une cellule capacitive 72. Dans cette réalisation, cela implique que le neurone 24 présente deux inverseurs 48 et 76 en série pour chaque condensateur 60.

Dans l'exemple proposé, l'alimentation des deux memristors vierges MV1 et MV2 est en parallèle pour que leur capacité s'additionne. Aussi, une sortie 76S d'un deuxième inverseur 76 est reliée à la fois à la source du premier transistor d'une cellule capacitive 72 et à la source du deuxième transistor de la même cellule capacitive 72. Il peut être rappelé ici que, par convention, dans le présent document, la notion de source et de drain est définie par rapport au sens de polarisation principal et qu'avec une polarisation inversée, drain et source sont échangés.

La ligne de sortie 74 reliée à la sortie des condensateurs 60 est connectée au comparateur 62 qui se trouve en périphérie de la matrice de cellules 14.

La ligne de sortie 74 est également connectée à un transistor de rappel 82 servant à effacer les memristors vierges MV1 et MV2 après calcul.

Similairement, un transistor de rappel 84 est inséré sur chaque ligne de source SL pour pouvoir mettre celle-ci à un potentiel nul.

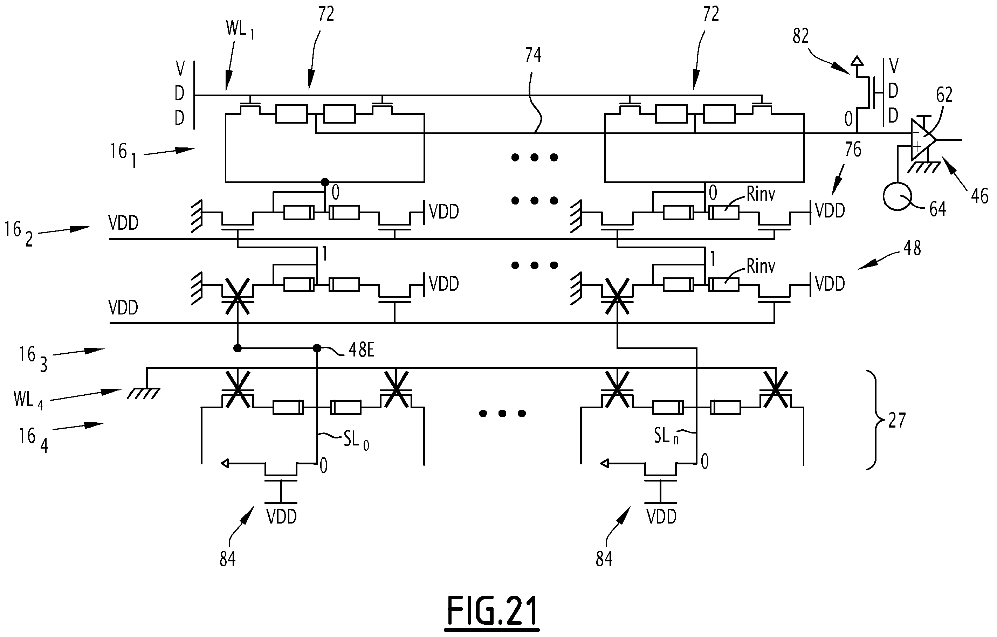

Le fonctionnement de ces transistors de rappel 82 et 84 est décrit en référence à la figure 21 qui illustre la configuration à utiliser pour effacer les memristors vierges MV1 et MV2.

Ainsi, pour mettre en oeuvre un tel effacement entre deux calculs, il suffit d'activer les transistors de rappel 82 et 84 tout en mettant les lignes de mot WL à la masse GND, tandis que la ligne de mot WL de l'unité de comptage 44 est mise au potentiel d'alimentation VDD.

La présente implémentation du circuit neuromorphique 10 permet donc de cumuler plusieurs avantages.

Comme la plupart des composants sont compris dans la surface occupée par la matrice de cellules 14, le circuit neuromorphique 10 est moins encombrant par rapport à une réalisation dans laquelle chaque neurone serait réalisé en périphérie de la matrice de cellules 14.

Par ailleurs, le circuit neuromorphique 10 présente une bonne intégrabilité dans un ensemble de cellules mémoires 26. De fait, la conversion d'une matrice de cellules mémoires 26 initiale en le circuit neuromorphique 10 est relativement aisée puisque seule la connectique des métaux par le dessus est impactée.

En outre, le circuit neuromorphique 10 utilise des ponts capacitifs 58 et 66 et dans chaque composant XNOR, le courant passe par une forte résistance. Il en résulte en une consommation réduite.

De plus, le circuit neuromorphique 10 gagne en robustesse du fait qu'il permet de supprimer la variabilité des memristors 28 et 30.

Le circuit neuromorphique 10 qui vient d'être décrit peut avantageusement être organisés en bancs pour effectuer des calculs en parallèle.

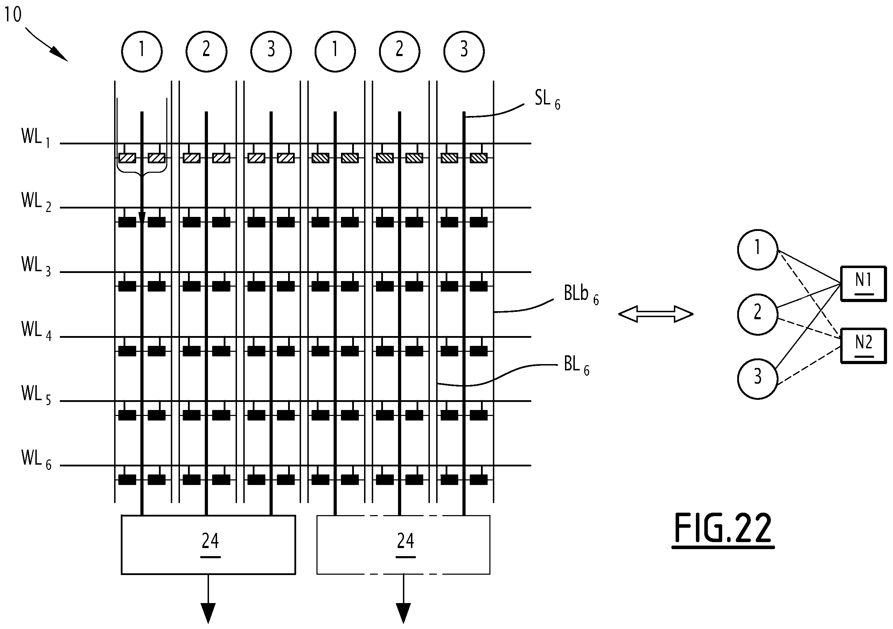

Pour cela, par exemple, en référence à la figure 22, une approche peut être de stocker les poids d'un neurone sur une même ligne 16 de la matrice de cellules 14, d'activer la ligne de mot WL correspondant à cette ligne 16 et de récupérer le résultat en sortie du neurone 24.

Plusieurs neurones 24 peuvent être calculés en parallèle en mettant sur la même ligne et à la suite les poids des différents neurones.

La figure 22 illustre un exemple pour le cas d'une implémentation pour trois neurones d'entrée reliés à deux neurones de sortie. Les éléments relatifs au calcul de la valeur donnée au premier neurone de sortie sont représentés en traits pleins tandis que les éléments relatifs au calcul de la valeur donnée au premier neurone de sortie sont représentés en traits pointillés.

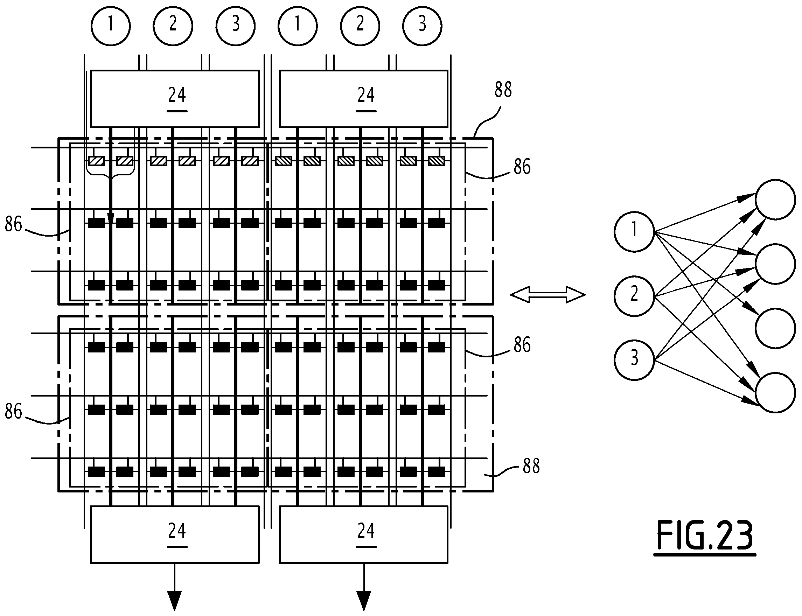

Pour augmenter le parallélisme, il est possible d'utiliser la configuration proposée à la figure 23. Dans cette configuration, les lignes de source SL sont coupées en milieu du la matrice de cellules 14 pour constituer plusieurs sous-ensembles 86 (mini-matrices) au sein de la matrice de cellules 14 et permettre un contrôle indépendant de ses sous-ensembles 86. Dans l'exemple représenté, le nombre n de sous-ensembles 86 est égal à 4.

Les n sous-ensembles 86 partageant les mêmes lignes de mot WL constituent un groupe de sous-ensembles 88. Chaque sous-ensemble 86 est associé à un neurone 24. Ainsi, en activant une ligne de mot WL par groupe de sous-ensembles 88, il est possible de calculer 2n sorties de neurones 24 en parallèle.

En complément, il pourrait être envisagé de couper les lignes de bits BL.

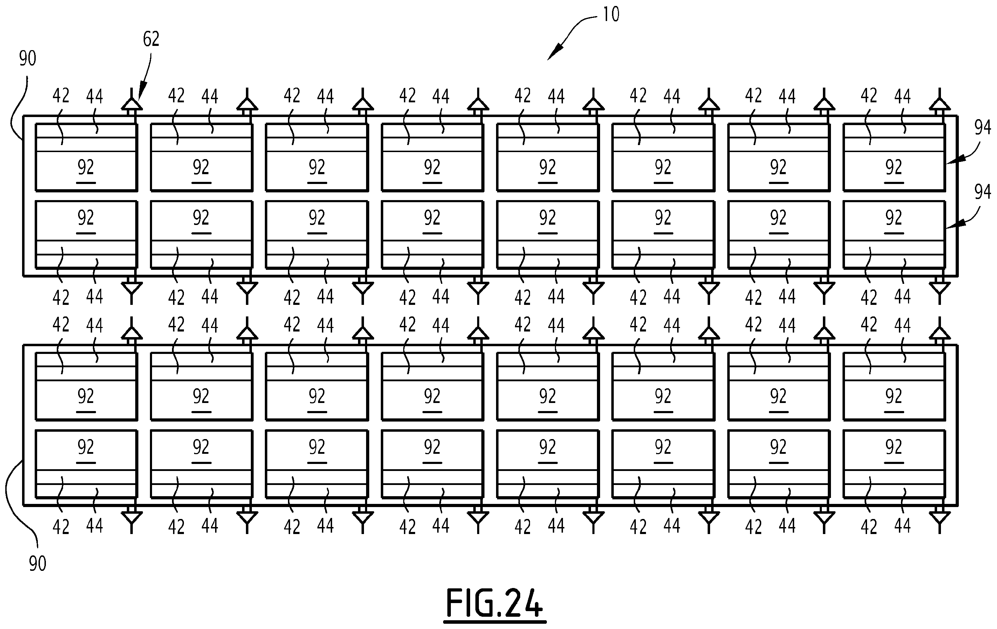

Comme illustré par la figure 24, il peut être envisagé une configuration avec un parallélisme amélioré. Le circuit neuromorphique 10 comporte ainsi plusieurs ensembles 90 (deux dans le cas de la figure 24) constitués chacun de plusieurs sous-ensembles 92 créés en interrompant les lignes de source SL au milieu de leur ensemble 90. Ainsi, en sélectionnant une ligne de mot WL par groupe d'ensemble 94, il est possible de calculer les sorties de chaque sous-ensemble 92 en parallèle. Les lignes de source SL de chaque sous-ensemble 92 peuvent être connectées à des lignes de source SL globales pour permettre l'écriture et la lecture des poids stockés de manière classique.

Comme cela est évident pour l'homme de l'art, l'écriture des poids dans les memristors est réalisée dans une étape préalable à une opération de calcul neuronal à proprement parler. De même, les valeurs des poids à mémoriser sont définis lors d'une opération d'entraînement du réseau de neurone préalablement à leur écriture en mémoire et donc préalablement au calcul neuronal lors de la réalisation notamment d'un calcul d'inférence neuronal.

Chacune des configurations décrites précédemment permettent d'effectuer des calculs conduisant à obtenir la sortie de plusieurs neurones 24 en parallèle et donc à augmenter les capacités calculatoires du circuit neuromorphique 10.

Chacun des modes de réalisation qui viennent d'être décrits sont compatibles avec d'autres modes de réalisation du neurone 24.

En particulier, il a été décrit que le composant XNOR 42 est réalisé par deux inverseurs 48 et 76 en série.

Ces inverseurs peuvent, en variante, réaliser une autre opération logique.

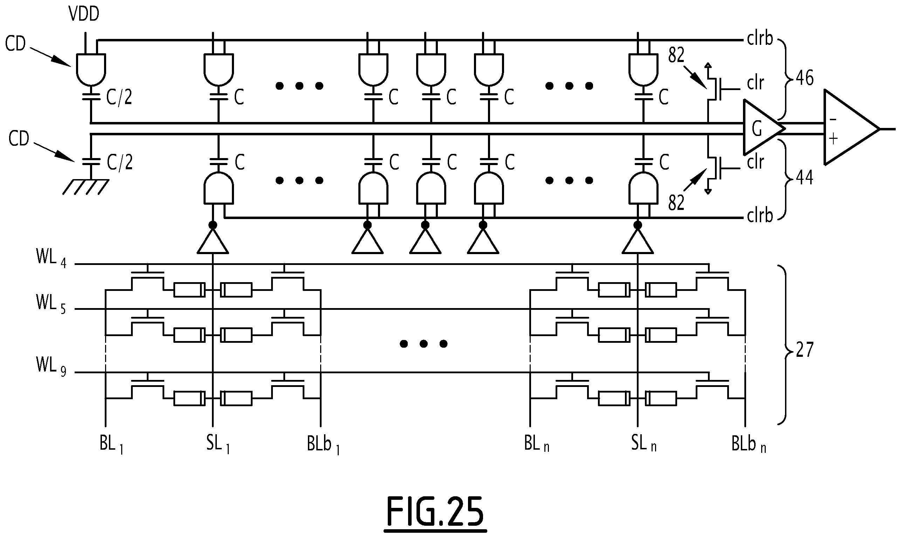

Ainsi, le premier inverseur 48 est remplacé par une unité logique réalisant une autre opération impliquant un basculement intermédiaire entre la masse GND et le potentiel d'alimentation VDD. Autrement formulé, le composant XNOR 42 comporte une unité logique 48 propre à effectuer une opération logique présentant un basculement entre une valeur basse et une valeur haute en fonction de la valeur de l'entrée de l'unité logique 48 qui est connectée à la ligne de source SL. Cela signifie que le composant XNOR 42 dépend uniquement de la valeur de la ligne de source SL considérée. Autrement formulé, l'unité logique 48 peut comporter éventuellement d'autres « entrées » que « l'entrée » correspondant à la ligne de source SL, par exemple dans un mode de réalisation tel que celui décrit infra en lien avec la figure 25, mais ces éventuelles autres entrées doivent avoir une valeur neutre lors d'une opération de calcul neuronal. Dès lors, la valeur en sortie de l'unité logique 48 dépend uniquement de la valeur présente sur la ligne de source SL lors d'une opération de calcul neuronal. En dehors des opérations de calcul neuronal, les éventuelles autres entrées de l'unité logique 48 peuvent, comme c'est le cas dans l'exemple en figure 25, prendre des valeurs non neutres de sorte à participer à l'établissement de la valeur de sortie de l'unité logique qui est reliée au pont capacitif.

Idéalement, la tension de basculement de l'opération réalisée par une telle unité logique est centrée autour de la moitié du potentiel d'alimentation, soit $\frac{VDD}{2}$, à une marge près, par exemple 5% près.

Cela signifie que l'unité logique 48 est, dans l'exemple décrit un inverseur ou une double inversion (ce qui revient à l'opération réalisée par un buffer). Par exemple, l'unité logique remplaçant le premier inverseur 48 est une porte XOR avec une entrée fixée à 0. XOR est l'appellation anglaise de l'opération logique « OU exclusif ».

Selon un autre exemple, l'unité logique remplaçant le premier inverseur 48 est une porte NAND avec une entrée fixée à 1. NAND est l'appellation anglaise de l'opérande « non ET ».

Selon encore un autre exemple, l'unité logique remplaçant le premier inverseur 48 est une porte NOR avec une entrée fixée à 0. NOR est l'appellation anglaise de l'opérande « non OU ».

Selon encore une autre variante représentée sur la figure 25, l'unité de comptage 44 et le générateur de tension de comparaison 64 sont tous les deux formés par des ponts capacitifs et comportent chacune un condensateur de décalage CD.

Il peut être noté que l'unité de comptage 44 est ici commandée par une chaîne de bits dont le nombre de 1 définit le seuil de comparaison et donc on peut utiliser n'importe quel seuil de comparaison.

Le condensateur de décalage CD présente une capacité égale à C/2.

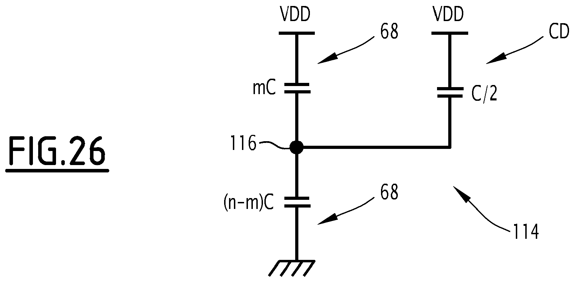

Dans une telle configuration, le schéma électrique équivalent de l'unité de comptage 44 est celui de la figure 26.

L'unité de comptage 44 correspond électriquement à un pont diviseur de capacité 114 comprenant m condensateurs 68 d'un côté et n-m condensateurs 68 d'un autre côté. Dans la notation précédente, n et m sont des entiers, m désignant le nombre de condensateurs 60 reliées à un composant XNOR 42 présentant une sortie correspondant à 1 et n le nombre total de condensateurs 60. Le point milieu 116 du pont diviseur de capacité 114 est relié à une borne du condensateur de décalage CD, l'autre borne du condensateur de décalage CD étant au potentiel d'alimentation VDD.

Le pont diviseur de capacité 114 étant connecté d'une part au potentiel d'alimentation VDD et d'autre part à la masse GND, il vient :

$$(m + 0{,}5).\Delta = \frac{m + 0{,}5}{n + 0{,}5}VDD$$

Où $\Delta$ est l'interseuil en tension entre deux états correspondant à deux valeurs de m successives.

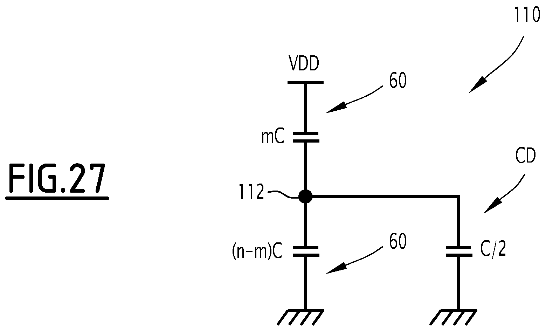

Similairement, en référence à la figure 27, le générateur de tension de comparaison 64 correspond électriquement à un pont diviseur de capacité 110 comprenant m condensateurs 60 d'un côté et n-m condensateurs 60 d'un autre côté. Le point milieu 112 du pont diviseur de capacité 110 est relié à une borne du condensateur de décalage CD, l'autre borne du condensateur de décalage CD étant reliée à la masse GND.

Le pont diviseur de capacité 110 étant connecté d'une part au potentiel d'alimentation VDD et d'autre part à la masse GND, avec les mêmes notations que précédemment, il vient :

$$m.\Delta = \frac{m}{n + 0{,}5}VDD$$

Des deux formules précédentes découlent deux constats, d'une part l'interseuil $\Delta$ est tel que $\Delta = \frac{1}{n + 0{,}5}VDD$ et d'autre part, il y a un décalage de 0,5 $\Delta$ entre les niveaux de tension de l'unité de comptage 44 et ceux du générateur de tension de comparaison 46.

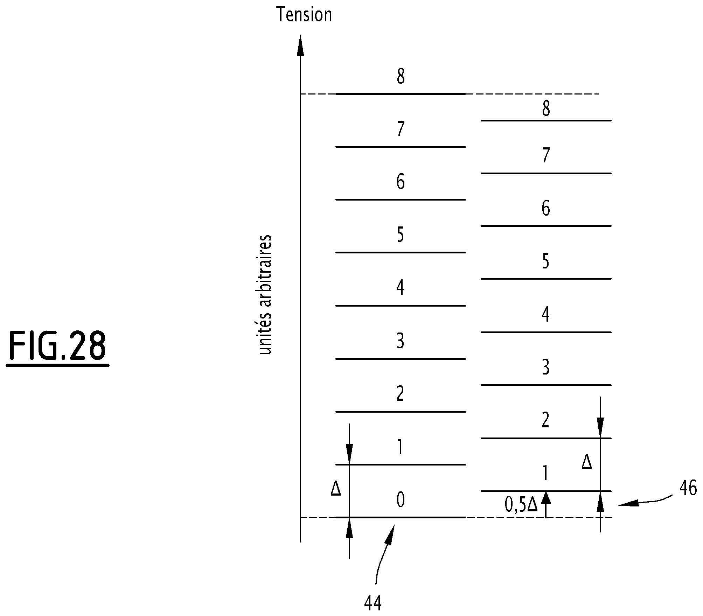

Comme cela apparaît sur la figure schématique de la figure 28, cela permet d'avoir une valeur de comparaison adaptée pour chaque niveau.

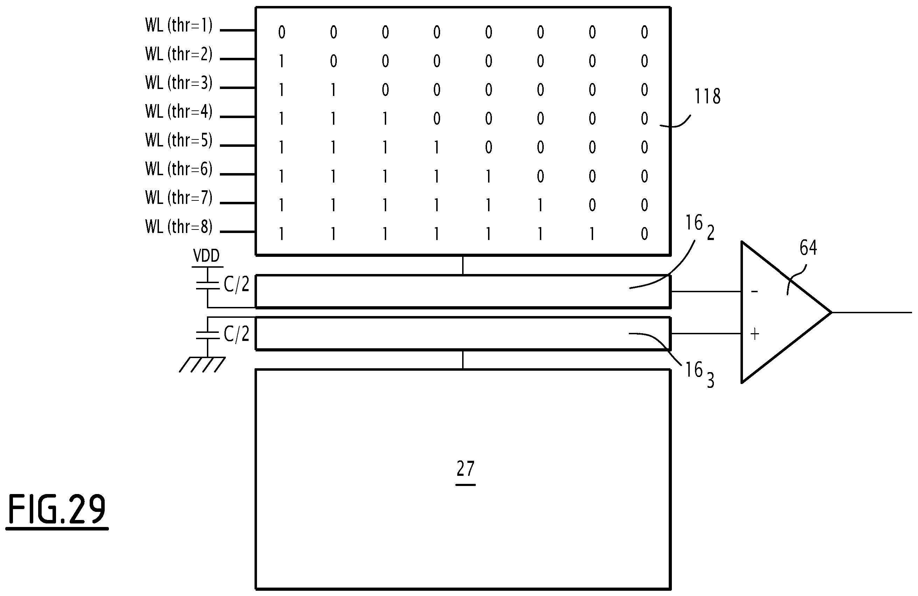

En variante, comme représenté sur la figure 29, il est possible d'utiliser une configuration dans laquelle les seuils sont stockés dans une matrice de cellule 118 et contrôlable par sélection de la ligne de mots WL souhaitée. Cela permet de générer de manière aisée une chaîne de bits désirée.

Enfin, du point de vue de l'implémentation physique, il a été proposé d'intégrer le neurone 24 sur les trois lignes $16_1$, $16_2$ et $16_3$ de la matrice de cellules 14, notamment en utilisant des cellules RRAM pour obtenir deux composants : des memristors et des condensateurs. Cela permet effectivement un gain en terme de place.

Toutefois, il est également possible de positionner le neurone 24 en périphérie de la matrice de cellules 14.

Il peut aussi être envisagé de réaliser les cellules élémentaires 12 en utilisant des cellules 1T1R dans lesquelles les lignes de sources seraient connectées deux à deux pendant le calcul. Dans une telle configuration, deux cellules 1T1R se comportent pendant le calcul comme une cellule 2T2R.

Par ailleurs, comme cela a été décrit, le circuit neuromorphique 10 est bien adapté pour une implémentation dans un circuit intégré plan, ou bidimensionnel (2D), c'est-à-dire un circuit réalisé sur un seul substrat, les composants électroniques de ce circuit étant réalisés les uns à côté des autres sur ce substrat.

En variante, le circuit neuromorphique 10 est réalisé sur un circuit intégré tridimensionnel (3D) qui correspond à un circuit électronique dont les composants électroniques sont répartis dans plusieurs couches (niveaux ou substrats) distinctes superposées les unes au-dessus des autres et reliées électriquement entre elles.

En particulier, il peut être envisagé des structures tridimensionnelles à nanofils empilés ou avec plusieurs tiers. Dans ce dernier cas, chaque ligne 16 de la matrice de cellules 14 a ses lignes de source SL connectées à un neurone situé sur le tiers supérieur. Il est alors possible d'envisager que les lignes de source SL soient connectées entre elles sur le troisième tiers.

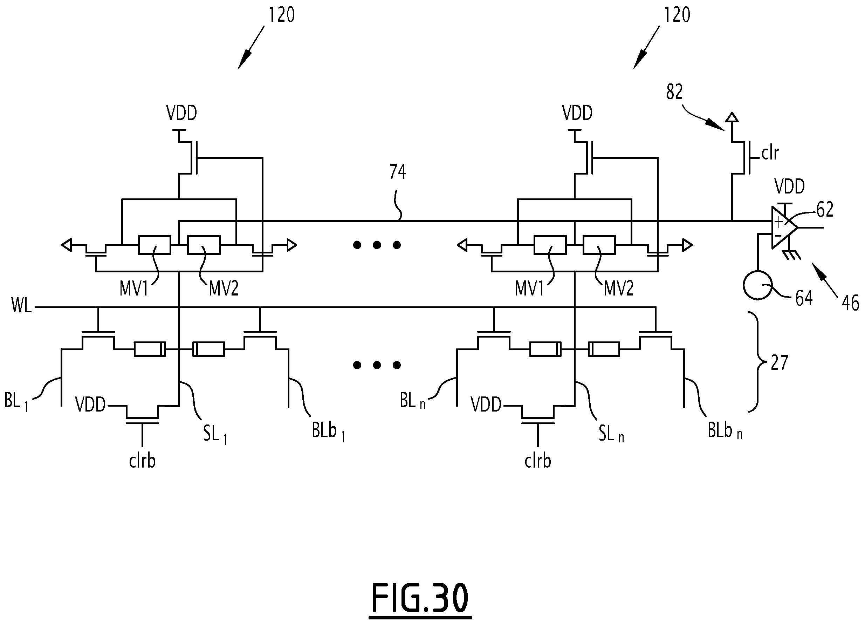

Il est également possible d'envisager des réalisations plus compactes du neurone 24 comme cela est illustré schématiquement par la figure 30. Par rapport à l'exemple représenté en figure 20, les deux inverseurs en série reliés au pont sont supprimés. La fonction inverseur est ici réalisée en utilisant les commutateurs associés aux mémoires MV1 et MV2 formant les éléments du pont.

Dans cet exemple, les commutateurs sont des transistors de type NMOS. Il est ainsi prévu d'ajouter un transistor PMOS 120 en bout de chaque ligne de source SL. Pour chaque colonne, nous avons donc un transistor PMOS 120 dont le drain est relié à une alimentation Vdd et la grille reliée à la ligne de source SL de la colonne. La source du transistor PMOS 120 est reliée aux drains des commutateurs reliés aux memresistors MV1 et MV2 de cette même colonne, cette liaison constituant l'équivalent de la sortie d'un inverseur formé par le transistor PMOS 120 et les deux commutateurs NMOS ainsi montés en parallèle.

Un autre transistor de type PMOS peut être prévu en bout de chaque ligne de source SL pour pouvoir réinitialiser l'état des éléments du pont, c'est-à-dire les memresistors MV1 et MV2. Ce transistor PMOS complémentaire permet, quand il est activé, de polariser à Vdd la ligne de source et par suite de polariser à gnd la sortie de l'inverseur formé par le transistor PMOS 120 et les commutateurs. Les deux électrodes de chaque memristor sont alors polarisés à Vdd lors de cette phase de réinitialisation des memristor.

Comme cela est évident pour l'homme de l'art, ces opérations de réinitialisation sont réalisées préalablement à une opération de calcul neuronal dans laquelle on réalise, comme précédemment décrit en lien notamment avec les figures 4 et 5, le calcul de popcount à partir des valeurs d'entrées du neurone appliquées sur les paires de lignes de bit complémentaires et de l'ensemble des poids synaptiques préalablement programmés (par écriture) dans les différentes cellules mémoires à base de memristors constituant les poids synaptiques.

Comme seule la manière d'implémenter l'unité logique 48 est modifiée, le fonctionnement du circuit neuromorphique 10 de la figure 30 est similaire à ce qui a été décrit précédemment.

De plus, ce circuit neuromorphique 10 présente les mêmes avantages auxquels viennent s'ajouter les avantages qui suivent.

Il n'est plus utile d'utiliser les lignes de cellules reliées aux lignes de mot $WL_2$ et $WL_3$. Il est par contre nécessaire de prévoir, en dehors de la matrice de cellules, n transistors PMOS. La surface occupée par le neurone 24 est globalement plus faible.

Cette variante est également intéressante parce que la réalisation physique de l'inversion par un « vrai inverseur CMOS » constitué d'un transistor PMOS et d'un transistor NMOS (les deux commutateurs en parallèle) permet de réaliser une inversion de meilleure qualité. De ce fait, cela permet d'obtenir une meilleure immunité par rapport à la variabilité des memristors, et donc une meilleure fiabilité des calculs effectués.

De plus, il n'est plus utile de mettre en oeuvre la procédure permettant de passer des cellules 2T2R non formées à deux inverseurs comme décrite en référence aux figures 17 à 19.

Cela permet de gagner en simplicité de mise en oeuvre du circuit neuromorphique 10.

Selon une variante de réalisation du double pont capacitif représenté en figure 5, il est possible d'ajouter une extension au double pont capacitif et à la matrice de cellules mémoires pour pouvoir ajuster le seuil $T_i$ du neurone à une valeur souhaitée, autre que le niveau de mi-alimentation $V_{DD}/2$.

Pour ce faire, on peut utiliser des unités de biais 200, chaque unité de biais 200 correspondant à un ensemble de deux condensateurs de biais montés en différentiel selon une structure similaire à celle décrite précédemment pour le pont capacitif.

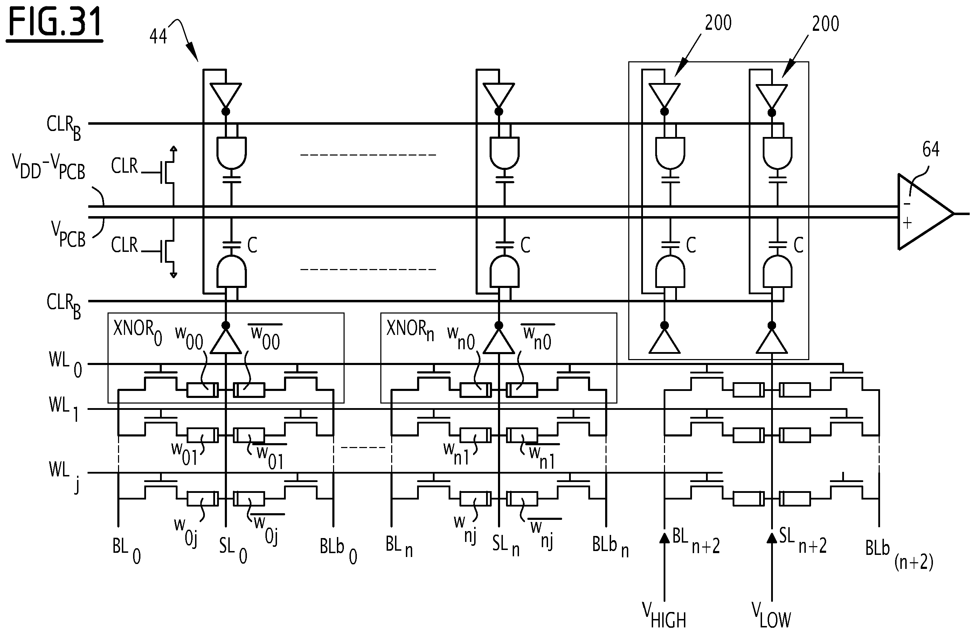

Comme visible sur la figure 30, chaque unité de biais 200 est reliée à une colonne supplémentaire et est contrôlée par un ensemble de cellules 2T2R reliées à une paire de lignes de bits complémentaires BL, BLb et une ligne de source SL additionnelles. En l'espèce, seule la colonne reliée à une unité de biais 200 est représentée sur la figure 31. En outre, comme pour les autres colonnes de la matrice, une unité logique est placée entre chaque colonne supplémentaire et chaque unité de biais 200.

Ainsi, il est possible de mettre chaque unité de biais 200 à 1 (respectivement à 0) en programmant les cellules mémoire de ces colonnes supplémentaires similairement à ce qui a été décrit précédemment par un contrôle de l'état des memristors. Une unité de biais 200 est dite « mise à « 1 » ou « 0 » » quand la sortie de l'inverseur en pied de colonne délivre par exemple respectivement une valeur de tension $V_{DD}$ ou gnd.

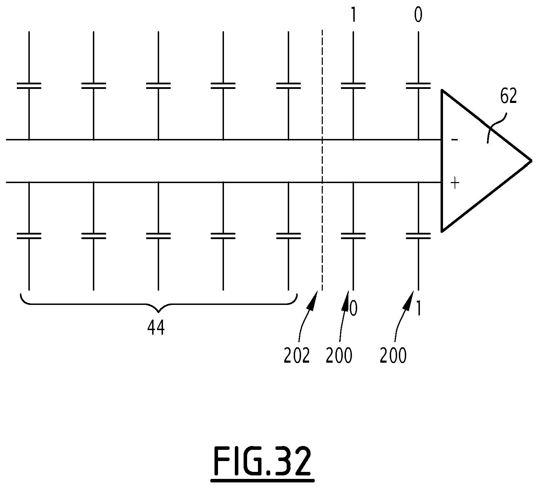

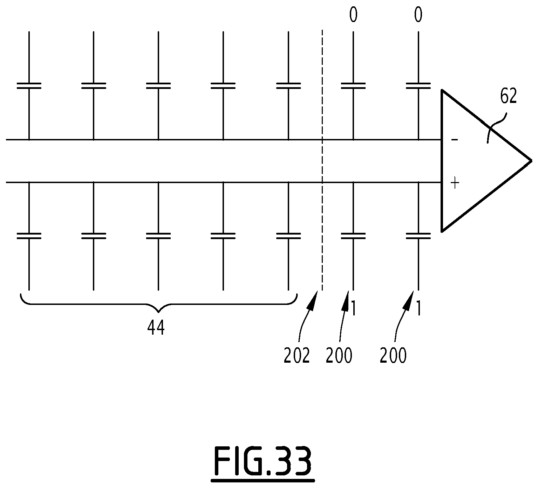

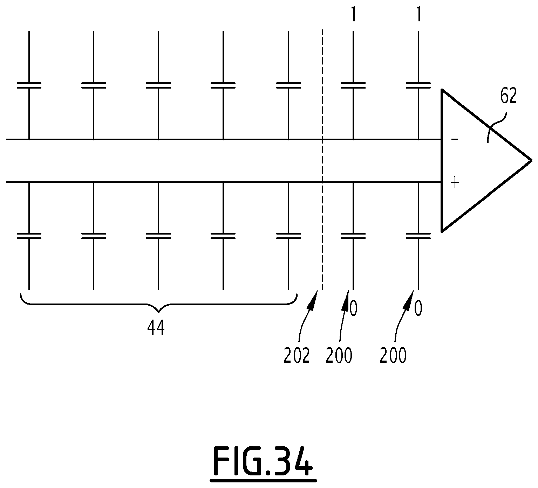

Les unités de biais 200 permettent de décaler le seuil du neurone autour de $V_{DD}/2$ comme cela va être expliqué sur les schémas des figures 32 à 34.

Pour rappel, la fonction de calcul susmentionnée exprimée en tensions s'écrit :

$$a_i = sign\left[\frac{V_{DD}}{n}[popcount_j\left(XNOR(W_{ij}, a_j)\right)] - T_i\right] \ avec \ T_i = \frac{V_{DD}}{2}$$

En tenant compte des unités de biais 200, elle devient :

$$a_i = sign\left[\frac{V_{DD}}{n+b}[popcount_j\left(XNOR(W_{ij}, a_j)\right)] - T_i'\right] \ avec \ T_i' = \frac{V_{DD}}{2} - \frac{V_{DD}}{n+b} * k_i$$

Où :

- $k_i$ correspondant au nombre d'unités de biais 200 à 1, et
- b étant le nombre d'unités de biais 200 total.

La même équation exprimée dans le domaine des entiers donne :

$$a_i = sign\left[[popcount_j\left(XNOR(W_{ij}, a_j)\right)] - T_i\right] \ avec \ T_i = \frac{n}{2} + \frac{b}{2} - k_i$$

Dans chacune de ces figures, les éléments de l'unité de comptage 44 et les unités de biais 200 sont représentés par deux condensateurs se faisant face. Les éléments de l'unité de comptage 44 sont à gauche d'une ligne en pointillée 202 qui les sépare des unités de biais 200 à droite.

Dans ce schéma, cinq éléments pour l'unité de comptage 44 (correspondant à cinq « branches synaptiques» d'entrée d'un même neurone dans la couche précédente) sont représentés. Comme décrit précédemment, chaque élément de l'unité de comptage 44 peut prendre la valeur 1 ou 0 selon le niveau de tension présent en sortie de l'inverseur relié à l'élément. Ainsi, le signal présent sur la ligne de mise en commun des charges reliée à l'entrée + du comparateur 62 peut prendre une valeur de tension parmi un ensemble de 6 valeurs possibles, que nous appellerons V1, V2, V3, V4, V5 et V6. Autrement dit, ce signal (sur l'entrée +) correspond en fait au résultat de l'opération popcount. Le résultat du popcount peut également être exprimé sous la forme d'un nombre entier, avec par exemple la valeur entière 0 correspondant à la tension V1, la valeur entière 1 correspondant à V2, et ainsi de suite jusqu'à la valeur entière 5 correspondant à V6.

On notera que les unités de biais 200 sont toujours à la même valeur logique de commande pour un neurone donné (ou autrement dit, pour une même ligne sélectionnée). En conséquence, peu importe leur nombre, cela ne change pas le nombre de valeurs de tension possible sur le signal « popcount » (sur l'entrée +). Par contre, le choix de la valeur attribuée à chaque unité de biais 200 va impacter les niveaux de tension correspondant aux 6 valeurs V1 à V6.

En l'absence d'unités de biais 200, les valeurs V1 à V6 correspondent par exemple respectivement à 0 V, $V_{DD}/5$, $2*V_{DD}/5$ et ainsi de suite jusqu'à V6 = $V_{DD}$. Avec deux unités de biais 200 à « 1 », les valeurs V1 à V6 correspondent alors respectivement à $(2/7)* V_{DD}$, $(3/7)* V_{DD}$ etc... jusqu'à $V_{DD}$. Avec deux unités de biais 200 à « 0 », les valeurs V1 à V6 correspondent alors respectivement à 0, $(1/7)* V_{DD}$, $(2/7)*V_{DD}$, jusqu'à $(5/7)* V_{DD}$.

La comparaison réalisée par le comparateur 62 correspond à la réalisation de la fonction sign() dans les équations susmentionnées, ainsi qu'à l'opération de soustraction de la valeur de seuil Ti. Dans le cas d'un pont capacitif différentiel tel que celui représenté en figure 32, la sortie du comparateur 62 va être haute ou basse selon respectivement que l'entrée + (borne 62E1) est supérieure ou inférieur à l'entrée - (borne 62E1) du comparateur 62. Autrement dit, si la tension sur le signal popcount (entrée +) est supérieure à $V_{DD}/2$ la sortie du comparateur 62 vaut « 1 » et si elle est inférieure à $V_{DD}/2$ la sortie du comparateur 62 vaut 0.

En l'absence d'unités de biais 200, les valeurs V1 à V6 sont réparties symétriquement autour de $V_{DD}/2$ et le résultat de la comparaison donne le résultat de la fonction sign(popcount) avec un seuil Ti égal à $V_{DD}/2$ si le signal popcount est exprimé en Volt, ou autrement dit avec un seuil Ti équivalent égal à 2.5 si le signal popcount est exprimé en nombre entier correspondant entre 0 et 5.

Avec les unités de biais 200, les valeurs V1 à V6 sont réparties différemment de part et d'autres de $V_{DD}/2$. Dans le premier exemple susmentionné (2 unités de biais 200 à « 1 »), nous avons ainsi 2 valeurs V1 et V2 inférieures à $V_{DD}/2$ et 4 valeurs V3 à V6 supérieures à $V_{DD}/2$. Le résultat de la comparaison donne donc le résultat de sign(popcount - Ti), avec le seuil Ti = (3/14) $V_{DD}$ Volt.

Avec 2 unités de biais 200, il est ainsi possible d'obtenir 3 valeurs de seuil Ti distinctes.

Plus généralement, avec m unités de biais 200, il est obtenu m+1 seuils. La valeur de ces seuils dépend en pratique du nombre de branches « d'entrée » du neurone, autrement dit du nombre de colonnes utilisées pour réaliser le neurone et du nombre d'unité(s) de biais 200..

Cela permet de disposer d'une structure aisée à réaliser pouvant fournir des valeurs de seuil différentes de la mi-alimentation $V_{DD}/2$. En pratique, si le nombre de colonnes reliées au neurone est élevé, on pourra faire varier la tension de seuil $T_i'$ autour de $V_{DD}/2$ avec quelques unités de biais 200 supplémentaires. Ceci est en pratique largement suffisant, car dans la majorité des applications la valeur de seuil Ti' souhaitée va être égale ou proche de $V_{DD}/2$.

En outre, cela permet d'envisager un entraînement plus « complet » d'un réseau de neurones en ajoutant la possibilité d'entraîner également les valeurs de seuil en plus des valeurs des poids.

Dans l'ensemble des modes de réalisations décrits précédemment, les valeurs « d'entrée » et de « sortie » de chaque neurone étaient codées sur un 1 seul bit. En ce sens, le circuit neuromorphique 10 réalise un réseau de neurones purement binaire, à savoir entrée binaire et sortie binaire.

Toutefois, le circuit neuromorphique 10 peut également être modifié pour prendre en entrée des valeurs « multi-bits », c'est-à-dire des valeurs codées sur plusieurs bits (chaque bit pouvant prendre 2 valeurs possibles) et sortir en sortie une valeur binaire. Dans un tel cas, on peut qualifier le réseau de neurones réalisé par le circuit neuromorphique 10 de réseau de neurones à sortie binaire.

Pour cela, comme indiqué précédemment, au niveau d'un neurone, on souhaite réaliser une opération qui peut s'écrire :

$$a_i = sign\left[popcount_j\left(XNOR(W_{ij}, a_j)\right) - T_i\right]$$

dans laquelle l'opération de popcount s'écrit :

$$popcount_j\left(XNOR(W_{ij}, x_j)\right) = \frac{V_{DD}}{n} * \sum_{j=1}^{n} x_j \odot W_{ij}$$

L'entier n désigne ici le nombre de branches synaptiques (ou nombre de colonnes) auxquelles le neurone i est connecté.

Par ailleurs, dans cette expression, pour simplifier la compréhension de ce qui va suivre, pour les entrées du neurone, au lieu d'utiliser la notation « $a_j$ » qui peut prêter à confusion avec la notation « $a_i$ », il sera utilisé la notation « $x_j$ » pour les entrées. Cette notation « $x_j$ » permet de bien différencier ces entrées des sorties « $a_i$ ».

L'opérateur $\odot$ désigne la multiplication bit à bit réalisée par une porte XNOR, de sorte qu'il vient :

$$popcount_j\left(XNOR(W_{ij}, x_j)\right)^{<k>} = \sum_{j=1}^{n} x_j^{\langle k \rangle} \odot W_{ij}^{\langle k \rangle}$$

Où :

- $x_j^{\langle k \rangle}$ désigne le k-ième bit de la j-ième entrée du neurone, et

- $W_{ij}^{\langle k \rangle}$ désigne le k-ième bit du poids binaire pour la j-ième entrée du neurone, k pouvant varier de 1 à m, m désignant le nombre total de bits pour chaque entrée $x_j$.

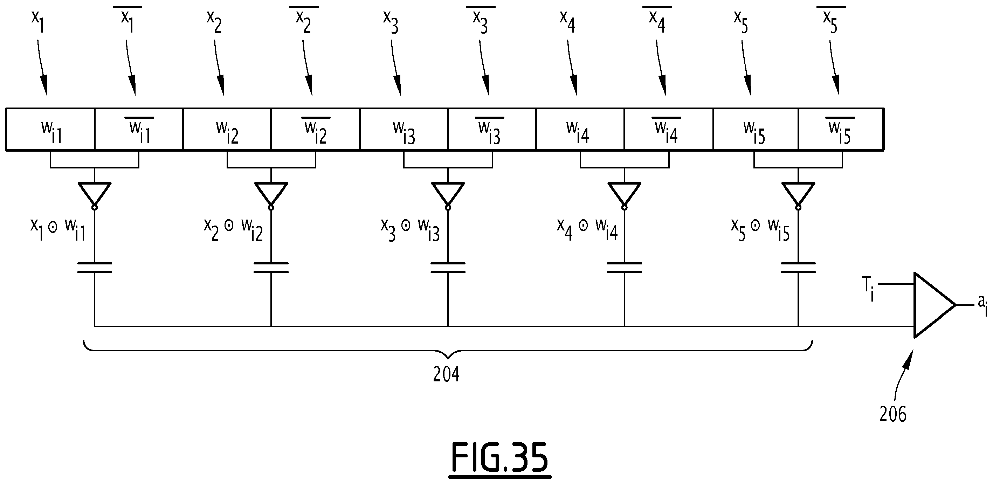

Or, ainsi que représenté schématiquement sur la figure 35 qui vise à schématiser les circuits exposés précédemment pour un exemple à 5 branches synaptiques par neurone et 1 seul bit pour chaque entrée (sur chaque paire de lignes de bit BL et BLb), le circuit neuromorphique 10 comporte une première partie 204 réalisant la fonction popcount et une deuxième partie 206 de comparaison réalisant l'opération sign et soustraction du seuil Ti.

Plutôt que de représenter chaque composant de la première partie 204 en intégralité, il est utilisé une représentation dans laquelle on voit un tableau avec des cases mémorisant un poids (respectivement $w_{i1}$, $\overline{w_{i1}}$ et ainsi de suite jusqu'à $\overline{w_{i5}}$). Chaque entrée ($x_1$ à $\overline{x_5}$) est à multiplier avec un poids indiqué par une flèche respective orientée vers le bas de la figure et touchant la case du poids.

Cette représentation simplifiée montre que les circuits exposés précédemment permettent avec les notations utilisées dans ce paragraphe de réaliser aisément uniquement l'opération de sommation pondérée suivante :

$$x_1.w_{i1} + x_2.w_{i2} + x_3.w_{i3} + x_4.w_{i4} + x_5.w_{i5}$$

On notera que dans une telle opération, on prend en compte un unique bit pour chaque valeur $x_j$.

De ce fait, pour réutiliser les circuits neuromorphiques 10 précédents, il faudra implémenter d'abord la somme sur j (compris entre 0 et n le nombre de colonnes/synapses) et ensuite la somme sur k (compris entre 1 et m), de sorte que l'opération de l'opération de popcount s'écrit :

$$popcount_j\left(XNOR(W_{ij}, x_j)\right) = \frac{V_{DD}}{n} * \frac{1}{2^{m+1}} \sum_{k=1}^{m} 2^k * \sum_{j=1}^{n} x_j^{\langle k \rangle} \odot W_{ij}^{\langle k \rangle}$$

Où m désigne le nombre total de bits pour chaque entrée $x_j$.

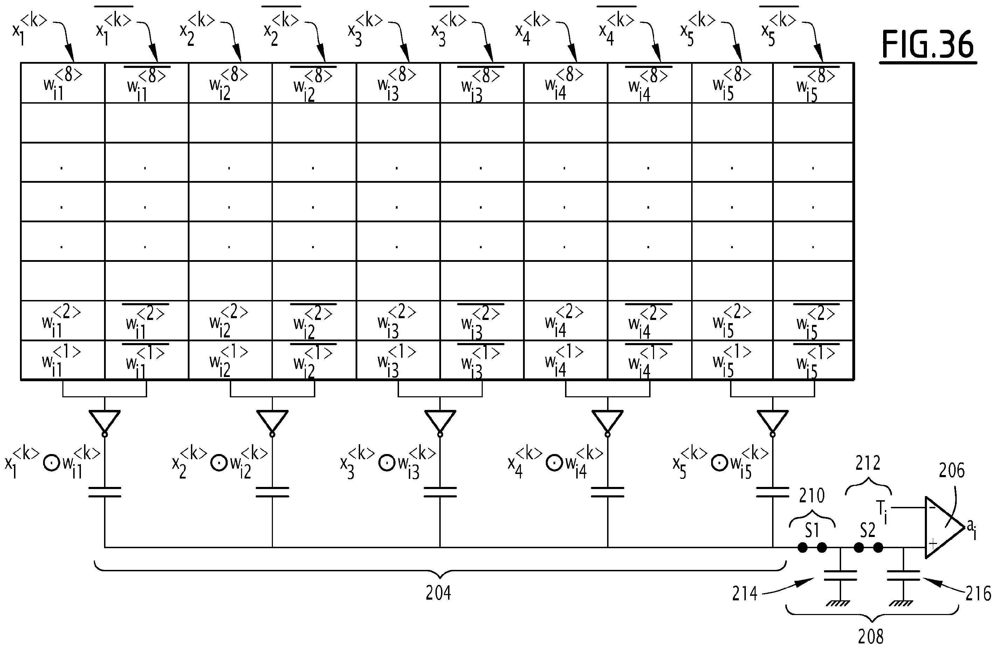

Une telle opération peut être mise en oeuvre séquentiellement par exemple au moyen de l'implémentation proposée sur la figure 36 décrit dans un exemple simple à 5 synapses (n=5) avec 8 bits (m=8) pour chaque donnée d'entrée $x_j$.

En réutilisant une représentation similaire à celle de la figure 35, dans ce cas, il est utilisé un poids pour chaque k-ème bit d'une donnée d'entrée $x_j$ au lieu d'un unique poids.

Cela conduit pour l'entrée $x_1$ à une colonne avec successivement $W_{i1}^{\langle 1 \rangle}$, $W_{i1}^{\langle 2 \rangle}$ ... $W_{i1}^{\langle 8 \rangle}$, et on va effectuer le calcul des multiplications de chacun de ces poids par chaque valeur du bit correspondant de l'entrée $x_1$. Ainsi, il est calculé $x_1^{\langle 1 \rangle} * W_{i1}^{\langle 1 \rangle}$, puis $x_1^{\langle 2 \rangle} * W_{i1}^{\langle 2 \rangle}$ et ainsi de suite jusqu'à $x_1^{\langle 8 \rangle} * W_{i1}^{\langle 8 \rangle}$. Comme dans les exemples décrits précédemment, ce calcul nécessite en pratique l'utilisation de lignes de bit complémentaires BL et BLb reliées à des cellules mémoires mémorisant des valeurs complémentaires dans les deux memristors de chaque cellule mémoire. Ainsi, la deuxième colonne, comme précédemment, mémorise les valeurs de poids complémentaires ( $\overline{W_{i1}^{\langle 1 \rangle}}$, $\overline{W_{i1}^{\langle 2 \rangle}}$ ... $\overline{W_{i1}^{\langle 8 \rangle}}$ ) et reçoit des valeurs de données complémentaires ( $\overline{x_1^{\langle 1 \rangle}}, ..., \overline{x_1^{\langle 8 \rangle}}$ ). Le circuit permet ainsi d'obtenir en sortie l'ensemble des résultats de chacune des opérations de type $x_j^{\langle k \rangle} * W_{ij}^{\langle k \rangle}$ et ce, de manière séquentielle.

Il convient encore d'accumuler ces éléments qui arrivent séquentiellement. C'est le rôle du dispositif de comptage 208 en sortie de la première partie 204.

Le dispositif de comptage 208 comporte une première unité 210 de transfert suivie d'une deuxième unité d'accumulation 212.

Pour cela, la première unité de transfert 210 comporte un premier interrupteur S1 et un condensateur, dit condensateur de transfert 214, tandis que la deuxième unité 212 comporte un deuxième interrupteur S2 et un autre condensateur, dit condensateur d'accumulation 216.

Un exemple de fonctionnement du dispositif de comptage 208 est maintenant décrit.

Préalablement aux opérations décrites ci-après, les deux condensateurs 214 et 216 sont réinitialisés, et dans l'exemple décrit ici on supprime les charges aux bornes des condensateurs 214 et 216 de sorte qu'une tension nulle est présente à leurs bornes.

La première partie 204 effectue d'abord les opérations de type $x_j^{\langle 1 \rangle} * W_{ij}^{\langle 1 \rangle}$ avec les deux interrupteurs S1 et S2 ouverts. Ces opérations sont réalisées en sélectionnant une première ligne mémorisant les poids avec l'indice k=1.

Puis, le premier interrupteur S1 est fermé pour transférer le résultat des opérations dans le condensateur de transfert 214 qui stocke une charge correspondant à une valeur de tension codant pour le résultat de la somme sur j *des* $x_j^{\langle 1 \rangle} * W_{ij}^{\langle 1 \rangle}$ .

Le premier interrupteur S1 est ensuite ouvert pour que la première partie 204 puisse effectuer de nouvelles opération, ici les opérations de type $x_j^{\langle 2\rangle} * W_{ij}^{\langle 2\rangle}$, en sélectionnant la ligne mémorisant les poids avec l'indice k=2.

Pendant ce temps, le deuxième interrupteur S2 est fermé de sorte que le condensateur de transfert 214 et le condensateur d'accumulation 216 sont reliés.

Le condensateur d'accumulation 216 se charge ainsi à une charge correspondant à moitié de la valeur de la tension de la capacité de transfert 214, c'est-à-dire:

$$\frac{V_{DD}}{n} * \frac{1}{2} \sum_{j=1}^{n} x_j^{\langle 1\rangle} * W_{ij}^{\langle 1\rangle}.$$

Puis, le deuxième interrupteur S2 est à nouveau ouvert et le condensateur de transfert 214 est remis à 0.

Le premier interrupteur S1 passe ensuite dans l'état fermé et ainsi le condensateur de transfert 214 est chargé à une charge correspondant à une valeur de tension codant pour le résultat de $\sum_{j=1}^{n} x_j^{\langle 2\rangle} * W_{ij}^{\langle 2\rangle}$, les opérations de type $x_j^{\langle 2\rangle} * W_{ij}^{\langle 2\rangle}$ venant d'être réalisées par la première partie 204.

Le premier interrupteur S1 est ensuite ouvert pour que la première partie 204 continue à effectuer des opérations, ici les opérations de type $x_j^{\langle 3\rangle} * W_{ij}^{\langle 3\rangle}$.

Pendant ce temps, le deuxième interrupteur S2 est fermé de sorte que le condensateur de transfert 214 et le condensateur d'accumulation 216 sont reliés.

Le condensateur d'accumulation 216 se charge ainsi à une charge correspondant à:

$$\frac{V_{DD}}{n} * \left[\frac{1}{2}\left(\frac{1}{2}\sum_{j=1}^{n} x_j^{\langle 1\rangle} * W_{ij}^{\langle 1\rangle} + \sum_{j=1}^{n} x_j^{\langle 2\rangle} * W_{ij}^{\langle 2\rangle}\right)\right]$$

$$= \frac{V_{DD}}{n} * \left[\frac{1}{4}\sum_{j=1}^{n} x_j^{\langle 1\rangle} * W_{ij}^{\langle 1\rangle} + \frac{1}{2}\sum_{j=1}^{n} x_j^{\langle 2\rangle} * W_{ij}^{\langle 2\rangle}\right].$$

En ainsi de suite jusqu'aux opérations de type $x_j^{\langle 8\rangle} * W_{ij}^{\langle 8\rangle}$ pour obtenir une charge sur le condensateur d'accumulation 216 correspondant à:

$$\frac{V_{DD}}{n} * \frac{1}{2^{m+1}} \sum_{k=1}^{m} 2^k * \sum_{j=1}^{n} x_j^{\langle k\rangle} * W_{ij}^{\langle k\rangle}$$

Une fois que l'accumulation est terminée, le comparateur 206 vient comparer la la tension présente sur le condensateur d'accumulation 216 avec une tension de référence qui est choisie en fonction d'un seuil $T_i$ que l'on souhaite appliquer dans la réalisation de la soustraction (avec $T_i$), le résultat de la comparaison effectuée par le comparateur 206 étant la valeur de sortie $a_i$.

Dans un tel mode de réalisation, les valeurs de charge que peut prendre le condensateur de transfert 210 sont très nombreuses, et par ricochet le nombre de valeurs possibles de charges sur le condensateur d'accumulation 216 après m transferts peut devenir rapidement très élevé si le nombre d'entrées n est élevé. Il en résulte que la discrimination par le comparateur 206 entre deux valeurs possibles successives, forcément proches l'une de l'autre, peut être rendue difficile en pratique ou peut nécessiter un comparateur très précis et donc encombrant et consommateur d'énergie.

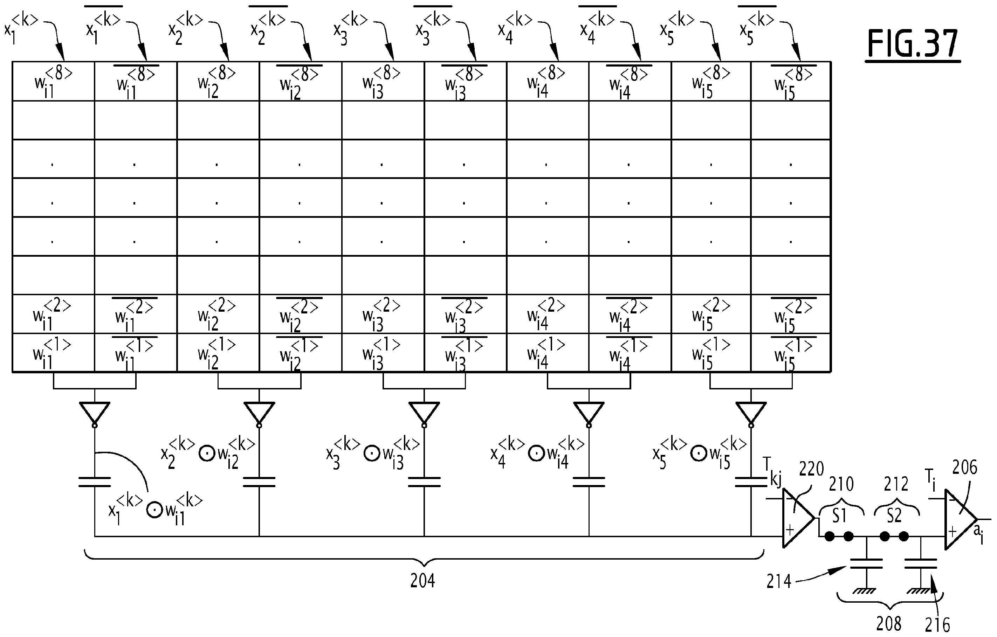

Pour remédier à cette problématique, selon une variante illustrée par la figure 37, un deuxième comparateur 220 est inséré en amont dispositif de comptage 208.

Le deuxième comparateur 220 effectue une comparaison avec un seuil noté $T_{ki}$.

En reprenant les notations précédentes, cela conduit à réaliser l'opération suivante :

$$a_i = sign\left(\frac{1}{2^{m+1}} \sum_{k=1}^{m} 2^k * sign\left(\frac{V_{DD}}{n} \sum_{j=1}^{n} x_j^{\langle k\rangle} * W_{ij}^{\langle k\rangle} - T_{ki}\right) - T_i\right)$$

La tension de référence appliquée sur l'entrée - du comparateur 206 est fonction du seuil $T_{ki}$. Selon un mode de réalisation le plus simple, une même valeur de tension de référence est appliquée durant tout le processus itératif expliqué ci-dessus (avec la sélection successive des m lignes).

Le condensateur de transfert 214 va dans cet exemple prendre une valeur parmi deux valeurs possibles, à savoir $V_{DD}$ ou Gnd. Par suite, le condensateur d'accumulation 216 pourra prendre, à la fin des m cycles d'accumulation, une valeur parmi 129 valeurs possibles dans le cas m=8 (si les deux condensateurs 214 et 216 sont de même capacité), ce qui peut permettre de réaliser plus facilement une discrimination entre deux niveaux successifs par un comparateur peu optimisé, de faible encombrement.

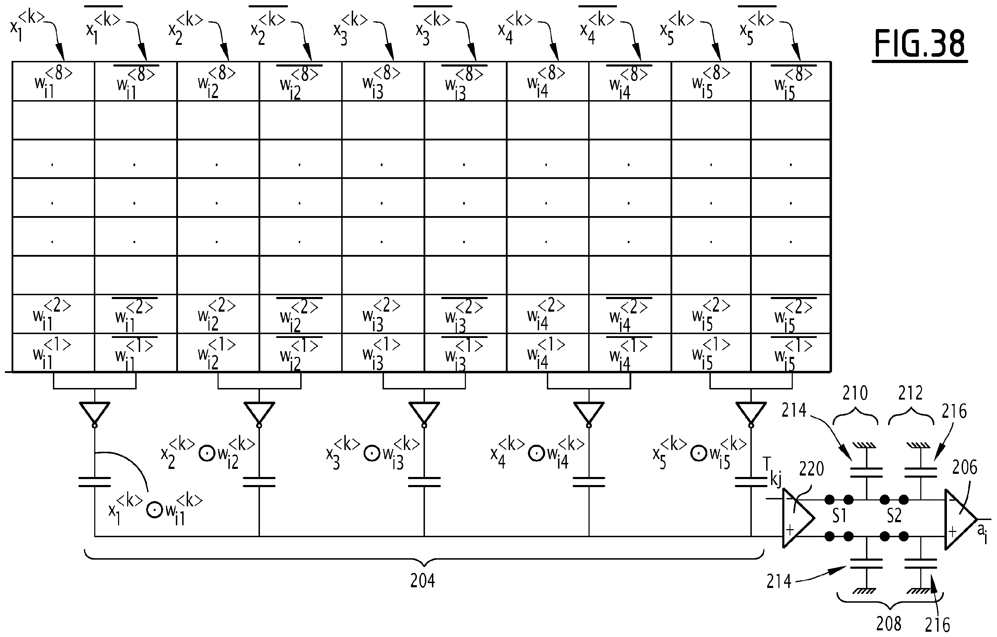

Selon encore une autre variante correspondant à la figure 38, tout en conservant le deuxième comparateur 220, la première unité 210 et la deuxième unité 212 sont réalisées selon un montage en différentiel.

Cela signifie que chacune des deux unités 210 et 212 comportent des interrupteurs et des condensateurs similaires placés en vis-à-vis selon deux voies.

Une telle variante permet d'obtenir une meilleure robustesse conférée par le montage en différentiel en terme de discrimination entre plusieurs niveaux, au niveau du deuxième comparateur 220 tout en ayant un pont capacitif "single" et non différentiel dans la partie 204 ce qui permet de limiter l'encombrement de cette partie 204 car sa taille peut rapidement devenir importante dans le cas d'un pont différentiel avec un nombre de colonnes élevé.

Selon une variante des deux modes de réalisation représentés respectivement en figures 37 et 38, il est éventuellement possible de ne pas prévoir le condensateur d'accumulation 216 et le comparateur 206 et d'utiliser en pratique uniquement le comparateur 220 pour fournir une suite de valeurs binaires en sortie du neurone, cette suite de m valeurs binaires (sur 1 bit) formant l'équivalent d'une valeur binaire "multi-bits" en sortie du neurone.

Par ailleurs, selon une variante du schéma représenté en figure 25, il est possible de prévoir un dispositif de réinitialisation du pont capacitif qui soit différent. Dans une telle variante, les portes ET sont supprimées et les sorties des inverseurs sont directement reliées aux condensateurs de chaque côté du pont capacitif. Lors d'une opération de réinitialisation, un dispositif de commande de la polarisation de chaque ligne de source SL de la matrice applique une tension nulle (GND) sur les SL, de sorte que les inverseurs "de droite" (reliés aux condensateurs reliés par ailleurs à l'entrée positive du comparateur 62) présentent une tension de sortie égale à $V_{DD}$ et les inverseurs "de gauche" (reliés aux condensateurs reliés par ailleurs à l'entrée négative du comparateur) présentent une tension de sortie égale à Gnd. Le transistor NMOS 82 "de droite" (celui relié à l'entrée positive du comparateur) est remplacé par un transistor PMOS 82' dont la source est relié à $V_{DD}$ et le drain relié à la ligne commune des condensateurs "de droite" (qui est reliée à l'entrée positive du comparateur). Ainsi, lors d'une opération de réinitialisation, préalablement à une opération de calcul neuronal, les condensateurs de gauche voient une tension nulle sur chacune de leurs bornes et les condensateurs de droites voient une tension égale à $V_{DD}$ sur chacune de leurs bornes ; ce qui conduit à l'évacuation des charges dans l'ensemble des condensateurs. On notera que le dispositif de commande de polariation de chaque ligne SL est bien entendu rendu inopérant lors d'une opération de calcul neuronal (sa sortie étant par exemple mise en état de haute impédance pour ne pas conduire de courant perturbateur).

Dans l'ensemble des modes de réalisation présentés, il a ainsi été présenté une implémentation d'un réseau de neurones qui peut être rendue compacte et présenter une faible consommation.

**Revendications**

1. Circuit neuromorphique (10) propre à mettre en oeuvre un réseau de neurones à sortie binaire, le circuit neuromorphique (10) comprenant :

   - des lignes de mot (WL),
   - des paires de lignes de bits complémentaires (BL, BLb),
   - des lignes de source (SL),
   - un ensemble de cellules élémentaires (12) organisées selon une matrice (14) bidimensionnelle comportant des lignes (16) et des colonnes (18),

     l'ensemble de cellules élémentaires (12) comportant un ensemble de mémorisation (27) regroupant un ensemble de lignes (16) de cellules élémentaires (12), les cellules élémentaires (12) de l'ensemble de mémorisation (27) étant des cellules mémoires (26), les cellules mémoires (26) d'une même ligne (16) étant sélectionnables par une ligne de mot (WL), les cellules mémoires (26) d'une même colonne (18) étant reliées à une paire de lignes de bits complémentaires (BL, BLb) et une ligne de source (SL),
     chaque cellule mémoire (26) comprenant deux memristors (28, 30) et deux commutateurs (32, 34), chaque memristor (28, 30) étant relié à la même ligne de source (SL) et à un commutateur (32, 34) respectif, chaque memristor (28, 30) mémorisant respectivement un poids ou l'inverse du même poids en présentant respectivement des première et deuxième valeurs de résistances différentes, les commutateurs étant reliés, pour leur activation, à une ligne de mot (WL) et reliés respectivement à une paire de lignes de bits complémentaires (BL, BLb), chaque paire de lignes de bits complémentaires recevant des tensions d'entrée complémentaires ($V_{in}$, $V_{inb}$) lors d'une opération de calcul neuronal,

- un circuit électronique implémentant un neurone (24) présentant une sortie et comportant :

- un ensemble de composants logiques (42), chaque composant logique (42) présentant une unité logique (48) comprenant une entrée connectée à une ligne de source (SL) respective, l'unité logique (48) étant propre à effectuer une opération logique présentant un basculement entre une valeur basse et une valeur haute en fonction uniquement de la valeur de l'entrée de l'unité logique (48) qui est connectée à la ligne de source (SL) lors de ladite opération de calcul neuronal, chaque unité logique (48) réalisant une fonction logique de type inverseur ou double inverseur,

- une unité de comptage (44), l'unité de comptage (44) étant propre à compter le nombre de valeurs hautes ou basses en sortie des composants logiques (42), l'unité de comptage (44) étant un pont (58, 96), un pont (58, 96) étant un ensemble de mêmes éléments (60, 98) en parallèle et reliés entre eux sur une de leurs bornes à une sortie de l'unité de comptage, chaque élément (60, 98) étant relié à un composant logique (42) respectif et étant une résistance (98) ou un condensateur (60),

- une unité de comparaison (46) comportant un comparateur (62) et un générateur de tension de comparaison (64), le comparateur (62) étant propre à comparer la sortie de l'unité de comptage (44) à la tension de comparaison générée par le générateur de tension de comparaison (64) pour émettre en sortie un signal dépendant de la comparaison et correspondant à la sortie du circuit électronique implémentant un neurone (24).

2. Circuit neuromorphique selon la revendication 1, dans lequel chaque memristor (28, 30) comporte un état vierge, l'unité de comptage (44) étant une ligne (16) de cellules élémentaires (12), chaque cellule élémentaire (12) de l'unité de comptage (44) étant une cellule comprenant deux memristors dans l'état vierge (MV1, MV2) et deux commutateurs (T1, T2), chaque memristor dans l'état vierge (28, 30) étant connecté à l'autre memristor dans l'état vierge (MV1, MV2) et à un commutateur (T1, T2) respectif, les commutateurs (T1, T2) étant reliés entre eux.

3. Circuit neuromorphique selon la revendication 1 ou 2, dans lequel chaque unité logique (48) comprend un inverseur formé à partir d'une cellule élémentaire (12) comprenant deux memristors (M1, M2) et deux commutateurs (TR, TT), chaque memristor (M1, M2) étant connecté à l'autre memristor (M1, M2) et à un commutateur (TR, TT) respectif, une piste de court-circuit ($P_{cc}$) étant agencée pour court-circuiter les deux memristors (M1, M2), un des commutateurs (T1, T2) étant relié à la masse et à l'entrée de l'unité logique pour sa commande et l'autre commutateur étant relié à un potentiel d'alimentation et monté en diode.

4. Circuit neuromorphique selon la revendication 1 ou 2, dans lequel chaque unité logique (48) comprend un inverseur formé à partir d'une cellule élémentaire (12) comprenant deux memristors (M1, M2) et deux commutateurs (TR, TT), chaque memristor (M1, M2) étant connecté à l'autre memristor (M1, M2) et à un commutateur (TR, TT) respectif, un premier commutateur (TR) étant relié à la masse et à l'entrée de l'unité logique pour sa commande et le deuxième commutateur (TT) étant relié à un potentiel d'alimentation et monté en diode, une piste de court-circuit ($P_{cc}$) étant agencée pour court-circuiter le memristor (M1) relié au premier commutateur (TR).

5. Circuit neuromorphique selon l'une quelconque des revendications 1 à 4, comprenant un premier contrôleur (20) permettant de sélectionner les cellules élémentaires d'une ligne qui sont reliées à une même ligne de mots (WL), et comprenant un deuxième contrôleur reliés aux paires de lignes de bit et permettant d'appliquer sur chaque paire de ligne de bits des tensions différentes et symétriques par rapport à une tension milieu, la tension appliquée sur une ligne de bit étant supérieure ou inférieur à celle appliquée sur la ligne de bit complémentaire associée selon la valeur d'un signal d'entrée, chaque signal d'entrée correspondant à une entrée d'une synapse reliée audit neurone.

6. Circuit neuromorphique selon la revendication 5, dans lequel l'ensemble formé par chaque unité logique (48) est réalisé à partir d'au moins une ligne ($16_2$, $16_3$) de cellules élémentaires (12) n'appartenant pas à l'ensemble de mémorisation (27).

7. Circuit neuromorphique selon la revendication 2, dans lequel chaque unité logique correspond à un inverseur (76) formé desdits commutateurs de chaque cellule élémentaire (12) de l'unité de comptage (44) et d'un transistor PMOS (120) dont le drain est relié à une tension d'alimentation (Vdd), la grille est reliée à une ligne de source SL et la source est reliée aux drains desdits commutateurs.

8. Circuit neuromorphique selon l'une quelconque des revendications 1 à 7, dans lequel le générateur de tension de comparaison (64) est un générateur de tension fixe.

9. Circuit neuromorphique selon l'une quelconque des revendications 1 à 8, dans lequel le générateur de tension de comparaison (64) est un deuxième pont (66, 100) présentant les mêmes éléments (68, 102) que l'unité de comptage (44), chaque élément (68, 102) du deuxième pont (66, 100) étant relié à un inverseur (70) connecté à une unité logique (42) respective.

10. Circuit neuromorphique selon la revendication 9, dans lequel les éléments des deux ponts (58, 66) sont des condensateurs (68) présentant la même capacité, le générateur de tension de comparaison (64) et l'unité de comptage (44) comportant un condensateur de décalage (CD), le condensateur de décalage (CD) présentant une capacité égale à la moitié de la capacité d'un condensateur (60, 68) d'un des deux ponts (58, 66).

11. Circuit neuromorphique selon l'une quelconque des revendications 1 à 10, dans lequel l'opération logique effectuée par chaque unité logique (48) est choisie parmi : un ou-exclusif avec une entrée fixée à 0, une inversion, un non-et avec une des deux entrées fixées à 1, un non-ou avec une des deux entrées fixées à 0.

12. Circuit neuromorphique selon l'une quelconque des revendications 1 à 11, dans lequel le circuit neuromorphique comporte des transistors de rappel (82, 84), un des transistors de rappel (82) étant relié à l'ensemble des éléments (60, 98) de l'unité de comptage (44) et les autres transistors de rappel (84) étant reliés à une ligne de source (SL) respective, les transistors de rappel (82, 84) étant propres à effacer les éléments (60, 68, 98, 102).

13. Circuit neuromorphique selon l'une quelconque des revendications 1 à 12, dans lequel le circuit neuromorphique (10) comporte plusieurs ensembles distincts de cellules élémentaires (12) propres à fonctionner en parallèle.

14. Circuit neuromorphique selon la revendication 13, dans lequel les lignes de sources (SL) présentent plusieurs portions, des portions de ces lignes étant spécifiques à un ensemble de cellules élémentaires (12).

15. Circuit neuromorphique selon l'une quelconque des revendications 1 à 14, dans lequel le circuit neuromorphique (10) est un circuit intégré tridimensionnel.

**Patentansprüche**

1. Neuromorphe Schaltung (10), die geeignet ist, um ein neuronales Netz mit binärem Ausgang zu implementieren, die neuromorphe Schaltung (10) umfassend:

   - Wortleitungen (WL),
   - Paare von komplementären Bitleitungen (BL, BLb),
   - - Source-Leitungen (SL); und
   - eine Menge von Elementarzellen (12), die in einer zweidimensionalen Matrix (14) umfassend Zeilen (16) und Spalten (18) organisiert sind,

      die Einheit von Elementarzellen (12) umfassend eine Speichereinheit (27), die eine Einheit von Zeilen (16) von Elementarzellen (12) gruppiert, wobei die Elementarzellen (12) der Speichereinheit (27) Speicherzellen (26) sind, die Speicherzellen (26) einer gleichen Zeile (16) durch eine Wortleitung (WL) auswählbar sind, die Speicherzellen (26) einer gleichen Spalte (18) mit einem Paar komplementärer Bitleitungen (BL, BLb) und einer Source-Leitung (SL) verbunden sind,
      jede Speicherzelle (26) umfassend zwei Memristoren (28, 30) und zwei Schalter (32, 34), wobei jeder Memristor (28, 30) mit derselben Source-Leitung (SL) und mit einem jeweiligen Schalter (32, 34) verbunden ist, wobei jeder Memristor (28, 30) jeweils ein Gewicht oder das Inverse desselben Gewichts speichert, indem er jeweils einen ersten und einen zweiten unterschiedlichen Widerstandswert aufweist, wobei die Schalter zu ihrer Aktivierung mit einer Wortleitung (WL) verbunden sind und jeweils mit einem Paar komplementärer Bitleitungen (BL, BLb) verbunden sind, wobei jedes Paar von komplementären Bitleitungen bei einem neuronalen Rechenvorgang komplementäre Eingangsspannungen ($V_{in}$, $V_{inb}$) empfängt,

- wobei eine elektronische Schaltung, die ein Neuron (24) implementiert, einen Ausgang aufweist und Folgendes umfasst:

- eine Gruppe von Logikkomponenten (42), wobei jede Logikkomponente (42) eine Logikeinheit (48) umfassend einen Eingang aufweist, der mit einer jeweiligen Source-Leitung (SL) verbunden ist, wobei die Logikeinheit (48) geeignet ist, um eine logische Operation durchzuführen, die ein Umschalten zwischen einem niedrigen Wert und einem hohen Wert nur abhängig von dem Wert des Eingangs der Logikeinheit (48) aufweist, die während der neuronalen Berechnungsoperation mit der Source-Leitung (SL) verbunden ist, wobei jede Logikeinheit (48) eine logische Funktion vom Typ Inverter oder Doppelinverter durchführt,
- eine Zähleinheit (44), wobei die Zähleinheit (44) geeignet ist, um die Anzahl der hohen oder niedrigen Werte an dem Ausgang der logischen Komponenten (42) zu zählen, wobei die Zähleinheit (44) eine Brücke (58, 96) ist, wobei eine Brücke (58, 96) ein Satz von gleichen Elementen (60, 98), die parallel geschaltet und an einem ihrer Anschlüsse an einem Ausgang der Zähleinheit miteinander verbunden sind, wobei jedes Element (60, 98) mit einer jeweiligen logischen Komponente (42) verbunden ist und ein Widerstand (98) oder ein Kondensator (60) ist,
- eine Vergleichseinheit (46), umfassend einen Komparator (62) und einen Vergleichsspannungsgenerator (64), wobei der Komparator (62) geeignet ist, um den Ausgang der Zähleinheit (44) mit der von dem Vergleichsspannungsgenerator (64) erzeugten Vergleichsspannung zu vergleichen, um ein Signal auszugeben, das von dem Vergleich abhängt und dem Ausgang der elektronischen Schaltung entspricht, die ein Neuron (24) implementiert.

2. Neuromorphe Schaltung nach Anspruch 1, wobei jeder Memristor (28, 30) einen Leerzustand umfasst, die Zähleinheit (44) eine Zeile (16) von Elementarzellen (12) ist, jede Elementarzelle (12) der Zähleinheit (44) eine Zelle ist, die zwei Memristoren in Leerzustand (MV1, MV2) und zwei Schalter (T1, T2) umfasst, wobei jeder Memristor in Leerzustand (28, 30) mit dem anderen Memristor in Leerzustand (MV1, MV2) und mit einem jeweiligen Schalter (T1, T2) verbunden ist, wobei die Schalter (T1, T2) untereinander verbunden sind.

3. Neuromorphe Schaltung nach Anspruch 1 oder 2, wobei jede Logikeinheit (48) einen Inverter umfasst, der aus einer Elementarzelle (12) mit zwei Memristoren (M1, M2) und zwei Schaltern (TR, TT) gebildet ist, wobei jeder Memristor (M1, M2) mit dem anderen Memristor (M1, M2) und einem Schalter (TR, TT) verbunden ist, wobei eine Kurzschlussbahn ($P_{CC}$) zum Kurzschließen der zwei Memristoren (M1, M2) angeordnet ist, wobei einer der Schalter (T 1, T2) mit Masse und dem Eingang der Logikeinheit zu deren Steuerung verbunden ist und der andere Schalter mit einem Versorgungspotential verbunden und als Diode geschaltet ist.

4. Neuromorphe Schaltung nach Anspruch 1 oder 2, wobei jede Logikeinheit (48) einen Inverter umfasst, der aus einer Elementarzelle (12) mit zwei Memristoren (M1, M2) und zwei Schaltern (TR, TT) gebildet ist, wobei jeder Memristor (M1, M2) mit dem anderen Memristor (M1, M2) und einem jeweiligen Schalter (TR, TT) verbunden ist, ein erster Schalter (TR) mit Masse und dem Eingang der Logikeinheit zu deren Steuerung verbunden ist und der zweite Schalter (TT) mit einem Versorgungspotential verbunden und als Diode geschaltet ist, wobei eine Kurzschlussbahn ($P_{CC}$) angeordnet ist, um den mit dem ersten Schalter (TR) verbundenen Memristor (M1) kurzzuschließen.

5. Neuromorphe Schaltung nach einem der Ansprüche 1 bis 4, umfassend eine erste Steuerung (20) zum Auswählen der Elementarzellen einer Zeile, die mit derselben Wortleitung (WL) verbunden sind, und eine zweite Steuerung, die mit den Bitleitungspaaren verbunden ist und es ermöglicht, an jedes Bitleitungspaar unterschiedliche Spannungen anzulegen, die symmetrisch zu einer mittleren Spannung sind, wobei die an eine Bitleitung angelegte Spannung höher oder niedriger als die an die assoziierte komplementäre Bitleitung angelegte Spannung ist, je nach dem Wert eines Eingangssignals, wobei jedes Eingangssignal einem Eingang einer mit dem Neuron verbundenen Synapse entspricht.

6. Neuromorphe Schaltung nach Anspruch 5, wobei die von jeder Logikeinheit (48) gebildete Einheit aus mindestens einer Zeile (162, 163) von Elementarzellen (12) realisiert wird, die nicht zu der Speichereinheit (27) gehören.

7. Neuromorphe Schaltung nach Anspruch 2, wobei jede Logikeinheit einem Inverter (76) entspricht, der aus den Schaltern jeder Elementarzelle (12) der Zähleinheit (44) und einem PMOS-Transistor (120) gebildet ist, dessen Drain mit einer Versorgungsspannung (Vdd) verbunden ist, dessen Gate mit einer Source-Leitung SL verbunden ist und dessen Source mit den Drains der Schalter verbunden ist

8. Neuromorphe Schaltung nach einem der Ansprüche 1 bis 7, wobei der Vergleichsspannungsgenerator (64) ein Festspannungsgenerator ist.

9. Neuromorphe Schaltung nach einem der Ansprüche 1 bis 8, wobei der Vergleichsspannungsgenerator (64) eine zweite Brücke (66, 100) ist, die denselben Elementen (68, 102) wie die Zähleinheit (44) aufweist, wobei jedes Element (68, 102) der zweiten Brücke (66, 100) mit einem Inverter (70) verbunden ist, der mit einer jeweiligen Logikeinheit (42) verbunden ist.

10. Neuromorphe Schaltung nach Anspruch 9, wobei die Elemente der zwei Brücken (58, 66) Kondensatoren (68) sind, die die gleiche Kapazität aufweisen, wobei der Vergleichsspannungsgenerator (64) und die Zähleinheit (44) einen Offset-Kondensator (CD) umfassen, wobei der Offset-Kondensator (CD) eine Kapazität aufweist, die gleich wie die Hälfte der Kapazität eines Kondensators (60, 68) einer der zwei Brücken (58, 66) ist.

11. Neuromorphe Schaltung nach einem der Ansprüche 1 bis 10, wobei die von jeder Logikeinheit (48) ausgeführte logische Operation ausgewählt ist aus: einem ausschließlichen OR mit einem auf 0 gesetzten Eingang, einer Inversion, einem Nicht-UND mit einem der zwei auf 1 gesetzten Eingänge, einem Nicht-OR mit einem der zwei auf 0 gesetzten Eingänge.

12. Neuromorphe Schaltung nach einem der Ansprüche 1 bis 11, wobei die neuromorphe Schaltung Rücksetztransistoren (82, 84) umfasst, wobei einer der Rücksetztransistoren (82) mit allen Elementen (60, 98) der Zähleinheit (44) verbunden ist und die anderen Rücksetztransistoren (84) mit einer jeweiligen Source-Leitung (SL) verbunden sind, wobei die Rücksetztransistoren (82, 84) zum Löschen der Elemente (60, 68, 98, 102) geeignet sind.

13. Neuromorphe Schaltung nach einem der Ansprüche 1 bis 12, wobei die neuromorphe Schaltung (10) mehrere unterschiedliche Sätze von Elementarzellen (12) umfasst, die geeignet sind, um parallel betrieben zu werden.

14. Neuromorphe Schaltung nach Anspruch 13, wobei die Source-Leitungen (SL) mehrere Abschnitte aufweisen, wobei Abschnitte dieser Leitungen für einen Satz von Elementarzellen (12) spezifisch sind.

15. Neuromorphe Schaltung nach einem der Ansprüche 1 bis 14, wobei die neuromorphe Schaltung (10) eine dreidimensionale integrierte Schaltung ist.


**Claims**

1. A neuromorphic circuit (10) suitable for implementing a neural network with binary output, the neuromorphic circuit (10) comprising:

   - word lines (WL),
   - pairs of complementary bit-lines (BL, BLb),
   - source lines (SL),
   - a set of elementary cells (12) organized according to a two-dimensional matrix (14) comprising rows (16) and columns (18),

      the set of elementary cells (12) including a storage assembly (27) grouping together a set of lines (16) of elementary cells (12), the elementary cells (12) of the storage assembly (27) being memory cells (26), where the memory cells (26) of the same line (16) can be selected by a word line (WL), the memory cells (26) of the same column (18) being connected to a pair of complementary bit-lines (BL, BLb) and a source line (SL), each memory cell (26) comprising two memristors (28, 30) and two switches (32, 34), each memristor (28, 30) being connected to the same source line (SL) and to a corresponding switch (32, 34)), each memristor (28, 30) storing a weight or the inverse of the same weight, respectively, and having different first and second resistance values, respectively, the switches being connected for the activation thereof, to a word line (WL) and correspondingly connected to a pair of complementary bit-lines (BL, BLb), each pair of complementary bit lines receiving complementary input voltages ($V_{in}$, $V_{inb}$) during a neural calculation operation,

   - an electronic circuit implementing a neurone (24) having an output and including:

      - a set of logic components (42), each logic component (42) having a logic unit (48) comprising an input connected to a corresponding source line (SL), the logic unit (48) being suitable for performing a logic operation which switches between a low value and a high value depending only on the value of the input of the logic unit (48) which is connected to the source line (SL) during said neuronal calculation operation, each logic unit (48) performing a logic function such as an inverter or a double inverter,

- a counting unit (44), the counting unit (44) being suitable for counting the number of high or low values at the output of the logic components (42), the counting unit (44) being a bridge (58, 96), a bridge (58, 96) being a set of the same elements (60, 98) in parallel and connected to each other at one of the terminals thereof to an output of the counting unit, each element (60, 98) being connected to a corresponding logic component (42) and being a resistor (98) or a capacitor (60),

- a comparison unit (46) comprising a comparator (62) and a comparison voltage generator (64), the comparator (62) being suitable for comparing the output of the counting unit (44) with the comparison voltage generated by the comparison voltage generator (64) so as to output a signal depending on the comparison and corresponding to the output of the electronic circuit implementing a neurone (24).

2. The neuromorphic circuit according to claim 1, wherein each memristor (28, 30) has a virgin state, the counting unit (44) being a line (16) of elementary cells (12), each elementary cell (12) of the counting unit (44) being a cell comprising two memristors in the virgin state (MV1, MV2) and two switches (T1, T2), each memristor in the virgin state (28, 30) being connected to the other memristor in the virgin state (MV1, MV2) and to a corresponding switch (T1, T2), the switches (T1, T2) being connected to each other.

3. The neuromorphic circuit according to claim 1 or 2, wherein each logic unit (48) comprises an inverter formed from an elementary cell (12) comprising two memristors (M1, M2) and two switches (TR, TT), each memristor (M1, M2) being connected to the other memristor (M1, M2) and to a corresponding switch (TR, TT), a short-circuit track ($P_{cc}$) being arranged for short-circuiting the two memristors (M1, M2), one of the switches (T1, T2) being connected to ground and to the input of the logic unit for the control thereof and the other switch being connected to a supply potential and mounted as a diode.

4. The neuromorphic circuit according to claim 1 or 2, wherein each logic unit (48) comprises an inverter formed from an elementary cell (12) comprising two memristors (M1, M2) and two switches (TR, TT), each memristor (M1, M2) being connected to the other memristor (M1, M2) and to a corresponding switch (TR, TT), a first switch (TR) being connected to the ground and to the input of the logic unit for the control thereof and the second switch (TT) being connected to a supply potential and mounted as a diode, a short-circuit track ($P_{cc}$) being arranged for short-circuiting the memristor (M1) connected to the first switch (TR).

5. The neuromorphic circuit according to any one of claims 1 to 4, comprising a first controller (20) for selecting the elementary cells of a line, which are connected to a same word line (WL), and comprising a second controller connected to the pairs of bit-lines and used for applying different voltages to each pair of bit-lines and symmetrical with respect to a middle voltage, where the voltage applied to a bit-line is either higher or lower than the voltage applied to the associated complementary bit-line depending on the value of an input signal, each input signal corresponding to an input of a synapse connected to said neurone.

6. The neuromorphic circuit according to claim 5, wherein the set formed by each logic unit (48) is formed from at least one line ($16_2$, $16_3$) of elementary cells (12) not belonging to the storage assembly (27).

7. The neuromorphic circuit according to claim 2, wherein each logic unit corresponds to an inverter (76) formed of said switches of each elementary cell (12) of the counting unit (44) and a PMOS transistor (120) the drain of which is connected to a supply voltage (Vdd), the gate of which is connected to a source line SL and the source of which is connected to the drains of said switches.

8. The neuromorphic circuit according to any one of claims 1 to 7, wherein the comparison voltage generator (64) is a fixed voltage generator.

9. The neuromorphic circuit according to any one of claims 1 to 8, wherein the comparison voltage generator (64) is a second bridge (66, 100) having the same elements (68, 102) as the counting unit (44), each element (68, 102) of the second bridge (66, 100) being connected to an inverter (70) connected to a corresponding logic unit (42).

10. The neuromorphic circuit according to claim 9, wherein the elements of the two bridges (58, 66) are capacitors (68) having the same capacitance, the comparison voltage generator (64) and the counting unit (44) having an offset capacitor (CD), the offset capacitor (CD) having a capacitance equal to one half of the capacitance of a capacitor (60, 68) of one of the two bridges (58, 66).

11. The neuromorphic circuit according to any one of claims 1 to 10, wherein the logic operation performed by each logic unit (48) is selected from: an exclusive-or with an input set to 0, an inversion, a non-and with one of the two inputs set to 1, a non-or with one of the two inputs set to 0.

12. The neuromorphic circuit according to any one of claims 1 to 11, wherein the neuromorphic circuit includes pull-down transistors (82, 84), one of the pull-down transistors (82) being connected to all of the elements (60, 98) of the counting unit (44) and the other pull-down transistors (84) being connected to a corresponding source line (SL), the pull-down transistors (82, 84) being suitable for erasing the elements (60, 68, 98, 102).

13. The neuromorphic circuit according to any one of claims 1 to 12, wherein the neuromorphic circuit (10) includes a plurality of distinct sets of elementary cells (12) suitable for working in parallel.

14. The neuromorphic circuit according to claim 13, wherein the source lines (SL) have a plurality of portions, where portions of the lines are specific to a set of elementary cells (12).

15. The neuromorphic circuit of any one of claims 1 to 14, wherein the neuromorphic circuit (10) is a three-dimensional integrated circuit.

## FIG.1

## FIG.2

**FIG.3**

## FIG.4

FIG.5

EP 4 137 999 B1

**FIG.6**

FIG.7

| IN | W | XNOR | 48S |
|----|---|------|-----|
| 0 | 0 | 1 | 1 |
| 0 | 1 | 0 | 0 |
| 1 | 0 | 0 | 0 |
| 1 | 1 | 1 | 1 |

**FIG.8**

$$\underline{FIG.9}$$

XNOR :

| $IA_{x,y,z}$ | $W^n_{i,j,k}$ | $O^n_{i,j,k}$ |
|---|---|---|
| GND | GND | VDD |
| GND | VDD | GND |
| VDD | GND | GND |
| VDD | VDD | VDD |

**FIG.10**

## FIG.11

FIG.12

EP 4 137 999 B1

**FIG.13**

FIG.14

EP 4 137 999 B1

FIG.15

FIG.16

FIG.17

EP 4 137 999 B1

FIG.18

EP 4 137 999 B1

**FIG.19**

**FIG.20**

EP 4 137 999 B1

**FIG.21**

FIG.22

EP 4 137 999 B1

**FIG.23**

EP 4 137 999 B1

FIG.24

FIG.25

EP 4 137 999 B1

FIG.26

EP 4 137 999 B1

EP 4 137 999 B1

## FIG.27

FIG.28

| | | | | | | | | |
|---|---|---|---|---|---|---|---|---|
| WL (thr=1) | 0 | 0 | 0 | 0 | 0 | 0 | 0 | 0 |
| WL (thr=2) | 1 | 0 | 0 | 0 | 0 | 0 | 0 | 0 |
| WL (thr=3) | 1 | 1 | 0 | 0 | 0 | 0 | 0 | 0 |
| WL (thr=4) | 1 | 1 | 1 | 0 | 0 | 0 | 0 | 0 |
| WL (thr=5) | 1 | 1 | 1 | 1 | 0 | 0 | 0 | 0 |
| WL (thr=6) | 1 | 1 | 1 | 1 | 1 | 0 | 0 | 0 |
| WL (thr=7) | 1 | 1 | 1 | 1 | 1 | 1 | 0 | 0 |
| WL (thr=8) | 1 | 1 | 1 | 1 | 1 | 1 | 1 | 0 |

118

$16_2$

64

VDD

C/2

C/2

$16_3$

27

## FIG.29

FIG.30

EP 4 137 999 B1

FIG.31

FIG.32

FIG.33

# FIG.34

EP 4 137 999 B1

$x_1 \odot w_{i1}$  $x_2 \odot w_{i2}$  $x_3 \odot w_{i3}$  $x_4 \odot w_{i4}$  $x_5 \odot w_{i5}$

204

206

FIG.35

FIG.36

EP 4 137 999 B1

FIG.37

FIG.38

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **L. WANG et al.** Efficient and Robust Nonvolatile Computing-In-Memory based on Voltage Division 2T2R RRAM with Input-Dependent Sensing Control. *Transactions on Circuits and Systems II: Express Briefs*, 19 March 2021
- **T. HIRTZIL et al.** *Digital Biologically Plausible Implementation of Binarized Neural Networks with Differential Hafnium Oxide Resistive Memory Arrays*, 12 August 2019

- **D. BANKMANN et al.** An always-on 3.8 m$\mu$J/86 % cifar 10 mixed-signal cnn processor with all memory on chip in 28-nm CMOS. *conférence ISSCC (International Solid - State Circuits Conference) organisée par l'IEEECC*, 2018
- **HOSSEIN VALAVI et al.** A Mixed-Signal Binarized Convolutional-Neural-Network Accelerator Integrating Dense Weight Storage and Multiplication for Reduced Data Movement. *symposium sur les circuits VLSI*, 2018